# EUROPEAN PATENT SPECIFICATION

(11) **EP 4 576 973 B1**
(45) Date of publication and mention of the grant of the patent: **30.09.2026**
(21) Application number: 24191177.5
(22) Date of filing: 26.07.2024
(51) Int. Cl.: H10B 12/00, H10B 41/20

(54) **SEMICONDUCTOR DEVICE**
HALBLEITERANORDNUNG
DISPOSITIF SEMI-CONDUCTEUR

(30) Priority: 19.12.2023 KR 20230186144
(43) Date of publication of application: 25.06.2025
(73) Proprietor: Samsung Electronics Co., Ltd., Suwon-si, Gyeonggi-do 16677 (KR)
(72) Inventor: SONG, Jaejoon, 16677 Suwon-si (KR); IHM, Jeongdon, 16677 Suwon-si (KR); YOON, Hyun-Chul, 16677 Suwon-si (KR)
(74) Representative: Marks & Clerk LLP

(56) References cited:
- US-A1- 2012 119 283
- US-A1- 2017 179 028
- US-A1- 2023 387 055

## Description

### FIELD

The present disclosure relates to a semiconductor device, and in particular, to a semiconductor device with a word line.

### BACKGROUND

Due to their small-sizes, multifunctionality, and/or low cost, semiconductor devices may be important in the electronics industry. The semiconductor devices may be classified into a semiconductor memory device for storing data, a semiconductor logic device for processing data, and a hybrid semiconductor device including both memory and logic elements.

With demand for high speed and low power consumption of electronic devices, semiconductor devices in the electronic devices may also be required to have high operating speeds and/or low operating voltages. In order to satisfy these requirements, it may be desirable to increase an integration density of the semiconductor device. However, as the integration density of the semiconductor device increases, the semiconductor device may suffer from deteriorated electrical characteristics and/or low production yield. Accordingly, research is being conducted to improve the electrical characteristics and production yield of semiconductor devices.

US 2023/387055 A1 discloses a microelectronic device which comprises a first microelectronic device structure and a second microelectronic device structure vertically overlying the first microelectronic device structure. The first microelectronic device structure comprises a first memory array region and a first control logic device region configured to effectuate control operations for memory cells of the first memory array region. The second microelectronic device structure comprises a second memory array region and a second control logic device region configured to effectuate control operations for memory cells of the second memory array region. Related memory devices, electronic systems, and methods are also described.

US 2012/119283 A1 discloses a plurality of vertical channels of semiconductor material which are formed to extend in a vertical direction through the plurality of insulation layers and the plurality of conductive patterns, a gate insulating layer between the conductive pattern and the vertical channels that insulates the conductive pattern from the vertical channels. Conductive contact regions of the at least two of the conductive patterns are in a stepped configuration. An etch stop layer is positioned on the conductive contact regions, wherein the etch stop layer has a first portion on a first one of the plurality of conductive patterns and has a second portion on a second one of the plurality of conductive patterns, wherein the first portion is of a thickness that is greater than a thickness of the second portion.

### SUMMARY

An embodiment of the inventive concept provides a semiconductor memory device with improved electric characteristics and an increased integration density. Aspects of the invention are provided according to independent claim 1.

According to an embodiment of the inventive concept, a semiconductor device includes a lower stack including a first lower word line, a first lower channel layer at least partially surrounded by the first lower word line, and a lower data storing structure connected to the first lower channel layer, an interlayer insulating layer on the lower stack, and an upper stack on the interlayer insulating layer, the upper stack including an upper word line, an upper channel layer at least partially surrounded by the upper word line, and an upper data storing structure connected to the upper channel layer, a lower connection contact on the first lower word line, a conductive connection line on the lower connection contact, and a penetration contact on the conductive connection line. The lower connection contact vertically overlaps the upper word line, and the penetration contact does not vertically overlap the upper word line.

According to an embodiment of the inventive concept, a semiconductor device may include a first lower word line, a first lower channel layer at least partially surrounded by the first lower word line, a first lower connection contact in contact with the first lower word line, a second lower word line stacked on the first lower word line, a second lower channel layer at least partially surrounded by the second lower word line, a second lower connection contact in contact with the second lower word line, a first upper word line stacked on the second lower word line, a first upper channel layer at least partially surrounded by the first upper word line, and a first upper connection contact in contact with the first upper word line. The first lower word line may include a first lower electrode portion at least partially enclosing the first lower channel layer and a second lower electrode portion in contact with the first lower connection contact. The second lower word line may include a first lower electrode portion at least partially enclosing the second lower channel layer and a second lower electrode portion in contact with the second lower connection contact. The first upper word line may include a first upper electrode portion at least partially enclosing the first upper channel layer and a second upper electrode portion in contact with the first upper connection contact. A length of the second lower electrode portion of the second lower word line may be less than a length of the second lower electrode portion of the first lower word line and may be less than a length of the second upper electrode portion of the first upper word line.

According to an embodiment of the inventive concept, a semiconductor device may include a lower stack, an interlayer insulating layer on the lower stack, an upper stack on the interlayer insulating layer, an upper insulating layer on the upper stack, a first conductive connection line and a second conductive connection line in the interlayer insulating layer, a first upper conductive line, a second upper conductive line, and a third upper conductive line in the upper insulating layer, a first lower connection contact in contact with a bottom surface of the first conductive connection line, a second lower connection contact in contact with a bottom surface of the second conductive connection line, an upper connection contact electrically connecting the first upper conductive line to the upper stack, a first penetration contact in contact with a bottom surface of the second upper conductive line and a top surface of the first conductive connection line, and a second penetration contact in contact with a bottom surface of the third upper conductive line and a top surface of the second conductive connection line. The lower stack may include a first lower word line in contact with a bottom surface of the first lower connection contact and a second lower word line in contact with a bottom surface of the second lower connection contact. The second conductive connection line may include a first portion in contact with a top surface of the second lower connection contact and a second portion in contact with a bottom surface of the second penetration contact. The first conductive connection line may be between the first and second portions of the second conductive connection line.

According to an embodiment of the inventive concept, a semiconductor device may include a first word line, a first channel layer at least partially surrounded by the first word line, a second word line on the first word line, a second channel layer on the first channel layer and at least partially surrounded by the second word line, a data storing structure connected to the first and second channel layers, a bit line connected to the first and second channel layers, a first penetration insulating pattern at least partially surrounded by the second word line, and a first connection contact electrically connected to the first word line. The first connection contact may include a first connecting portion in contact with the first word line and an upper portion at least partially surrounded by the second word line and the first penetration insulating pattern. A width of the first connecting portion may be greater than a width of the upper portion.

At least some of the above and other features of the invention are set out in the claims.

### BRIEF DESCRIPTION OF THE DRAWINGS

FIG. 1 is a circuit diagram schematically illustrating a semiconductor device according to an embodiment of the inventive concept.
FIGS. 2A, 2B, and 2C are perspective views schematically illustrating a semiconductor device according to an embodiment of the inventive concept.
FIG. 3A is a plan view illustrating a semiconductor device according to an embodiment of the inventive concept.
FIG. 3B is a sectional view taken along a line A-A' of FIG. 3A.
FIG. 3C is a sectional view taken along a line B-B' of FIG. 3A.
FIG. 3D is a perspective view illustrating word lines and channel layers.
FIG. 3E is a plan view illustrating conductive connection lines.
FIG. 4 is a plan view illustrating conductive connection lines of a semiconductor device according to an embodiment of the inventive concept.
FIGS. 5A and 5B are sectional views illustrating a semiconductor device according to an embodiment of the inventive concept.
FIG. 6 is a sectional view illustrating a semiconductor device according to an embodiment of the inventive concept.
FIG. 7 is a sectional view illustrating a semiconductor device according to an embodiment of the inventive concept.
FIG. 8 is a sectional view illustrating a semiconductor device according to an embodiment of the inventive concept.
FIG. 9 is a plan view illustrating a semiconductor device according to an embodiment of the inventive concept.
FIG. 10 is a plan view illustrating a semiconductor device according to an embodiment of the inventive concept.

### DETAILED DESCRIPTION OF EMBODIMENTS

Embodiments of the inventive concepts will now be described more fully with reference to the accompanying drawings, in which example embodiments are shown. It will be understood that when an element or layer is referred to as being "on" or "above" another element or layer, it may be directly on another element or layer, or other element(s) or layer(s) may be interposed therebetween. In contrast, when an element is referred to as "directly on" or "directly above" another element or layer, there are no intervening elements or layers. As used herein the term "and/or" includes any and all combinations of one or more of the associated listed items. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "connected" may be used herein to refer to a physical and/or electrical connection. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

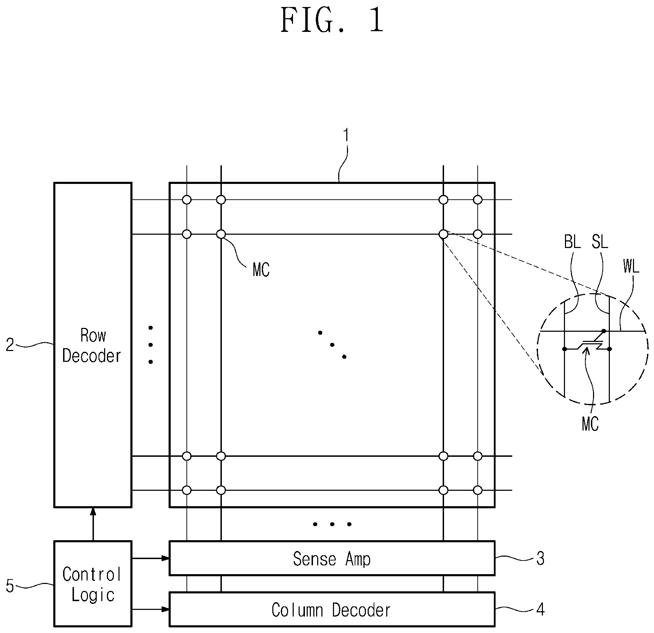

FIG. 1 is a circuit diagram schematically illustrating a semiconductor device according to an embodiment of the inventive concept.

Referring to FIG. 1, the semiconductor device may include a memory cell array 1, a row decoder 2, a sense amplifier 3, a column decoder 4, and a control logic 5.

The memory cell array 1 may include word lines WL, bit lines BL, source lines SL, and memory cells MC. The memory cells MC may be three-dimensionally arranged, and each of the memory cells MC may be connected to one of the word lines WL, one of the bit lines BL, and one of the source lines SL. In an embodiment, each of the memory cells MC may be composed of one transistor including a memory layer or a data storing layer.

The row decoder 2 may be configured to decode address information, which is input from the outside (i.e., from an external device), and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control of a control circuit.

The sense amplifier 3 may be configured to sense, amplify, and output a difference in voltage between one of the bit lines BL, which is selected based on address information decoded by the column decoder 4, and a reference bit line.

The column decoder 4 may be configured to establish a data transmission path between the sense amplifier 3 and an external device (e.g., a memory controller). The column decoder 4 may be configured to decode address information, which is input from the outside, and to select one of the bit lines BL, based on the decoded address information.

The control logic 5 may be configured to generate control signals, which are used to control data-writing or data-reading operations on the memory cell array 1.

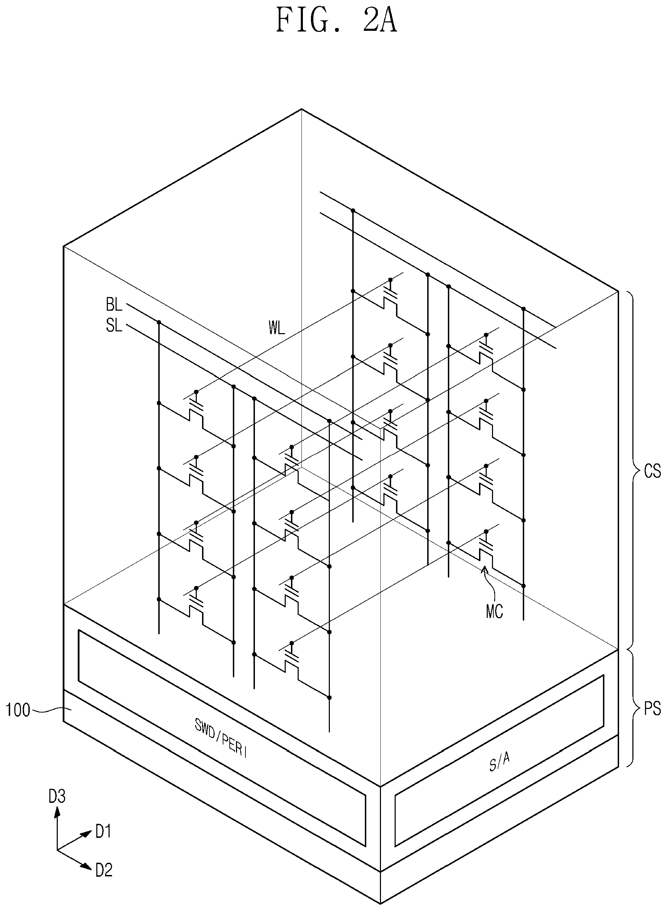

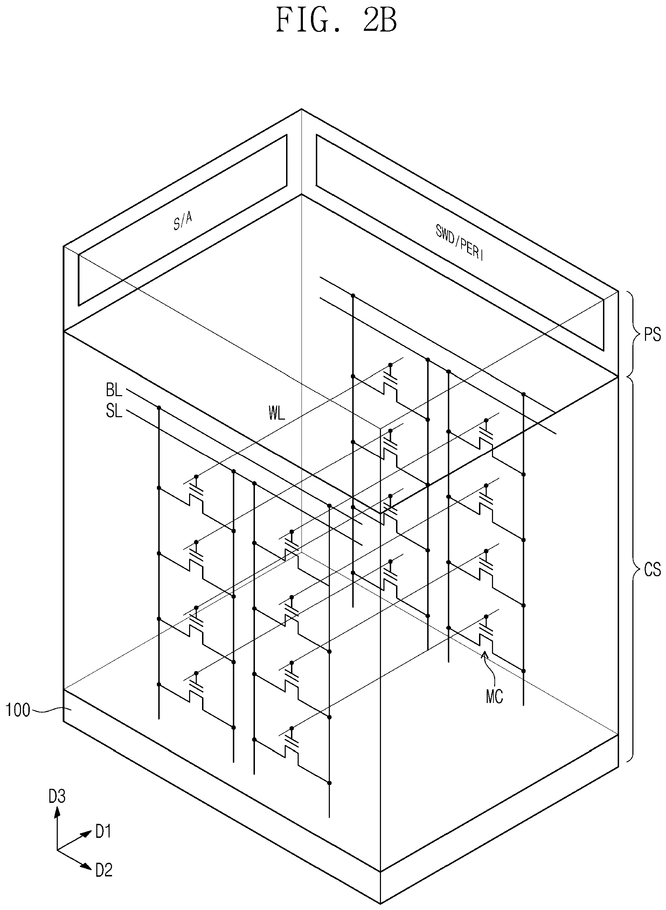

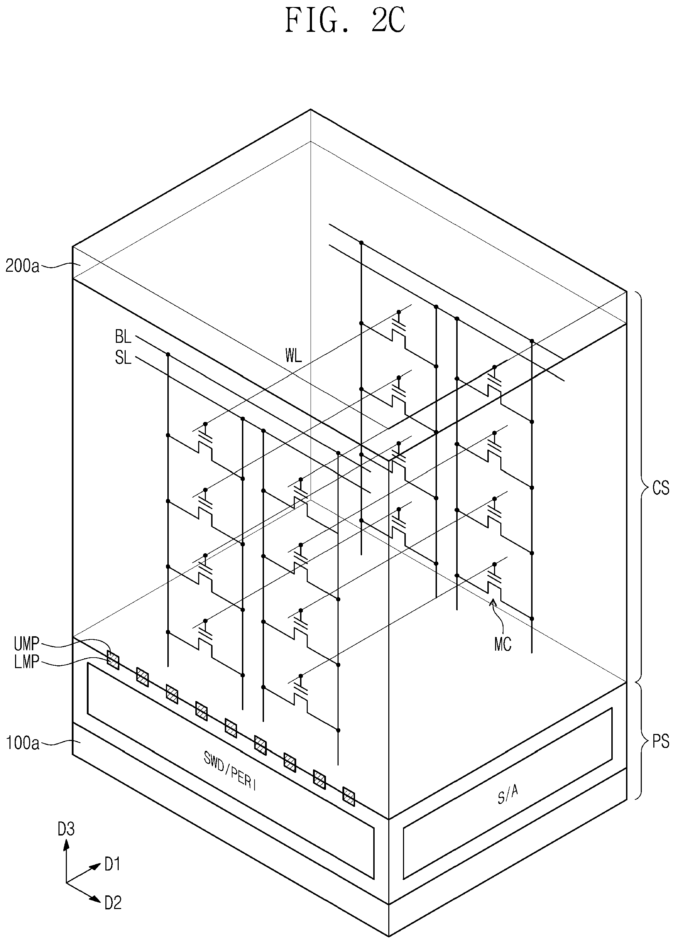

FIGS. 2A, 2B, and 2C are perspective views schematically illustrating a semiconductor device according to an embodiment of the inventive concept.

Referring to FIG. 2A, the semiconductor device may include a substrate 100, a peripheral circuit structure PS on the substrate 100, and a cell array structure CS on the peripheral circuit structure PS.

The peripheral circuit structure PS may include core and peripheral circuits formed on the substrate 100. The core and peripheral circuits may include the row and column decoders 2 and 4, the sense amplifier 3, and the control logic 5 described with reference to FIG. 1.

The substrate 100 may be a planar or plate-shaped structure that extends parallel to a plane defined by a first direction D1 and a second direction D2. The first and second directions D1 and D2 may not be parallel to each other. In an embodiment, the first and second directions D1 and D2 may be horizontal directions that are orthogonal to each other. The peripheral circuit structure PS and the cell array structure CS may be sequentially stacked on the substrate 100 in a third direction D3. The third direction D3 may not be parallel to the first and second directions D1 and D2. As an example, the third direction D3 may be a vertical direction that is orthogonal to the first and second directions D1 and D2. As such, the term "stack" or "stacked" may refer to an arrangement of elements that are positioned on top of one another in the vertical direction (e.g., in direction D3). The terms "horizontal" and "vertical" are relative directions based on the structure of the semiconductor device. Accordingly, these terms do not imply any particular orientation of the semiconductor device in use.

The cell array structure CS may include the bit lines BL, the source lines SL, the word lines WL, and the memory cells MC therebetween. Each of the memory cells MC may be connected to one word line WL, one bit line BL, and one source line SL.

Referring to FIG. 2B, the semiconductor device may include the cell array structure CS on the substrate 100 and the peripheral circuit structure PS on the cell array structure CS. The cell array structure CS may be disposed between the substrate 100 and the peripheral circuit structure PS. The peripheral circuit structure PS may include the core and peripheral circuits.

Referring to FIG. 2C, the semiconductor device may have a chip-to-chip (C2C) structure. The peripheral circuit structure PS may include a first substrate 100a. Lower metal pads LMP may be provided in the uppermost portion of the peripheral circuit structure PS. The lower metal pads LMP may be electrically connected to the core and peripheral circuits. The lower metal pads LMP may be bonded to upper metal pads UMP of the cell array structure CS. Spatially relative terms such as 'top,' 'above,' 'upper,' 'upper portion,' 'upper surface,' 'bottom,' 'below,' 'lower,' 'lower portion,' 'lower surface,' 'side surface,' and the like may refer to the orientations illustrated by way of example in the drawings or relative to a reference element or layer, such as a substrate. It will be understood that such spatially relative terms are intended to encompass different orientations of the device in addition to the orientation depicted in the figures.

The cell array structure CS may include a second substrate 200a, and the upper metal pads UMP may be provided in the lowermost portion of the cell array structure CS. The upper metal pads UMP may be electrically connected to the bit lines BL, the source lines SL, and the word lines WL. The upper metal pads UMP may be electrically connected to the memory cells MC.

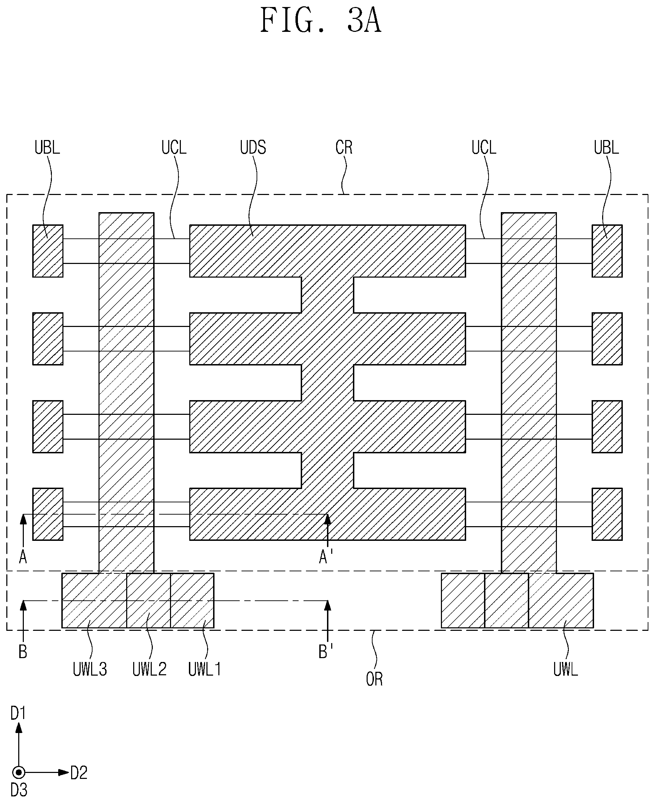

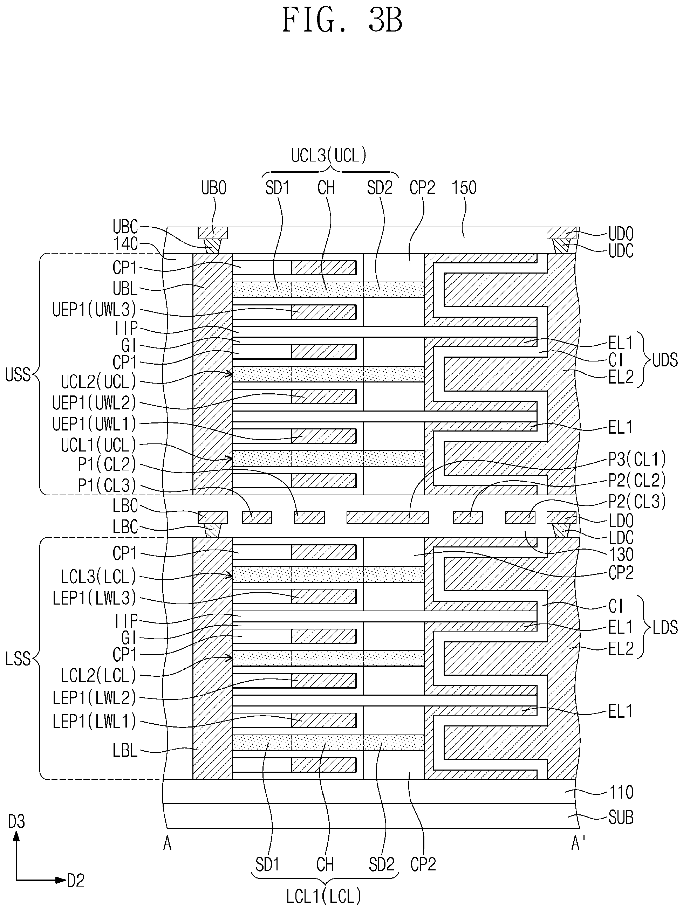

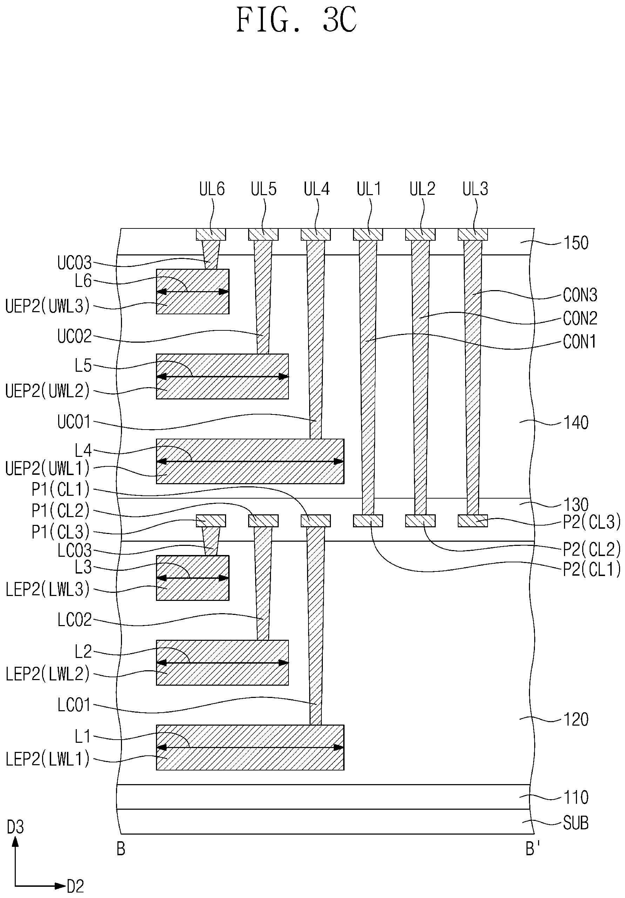

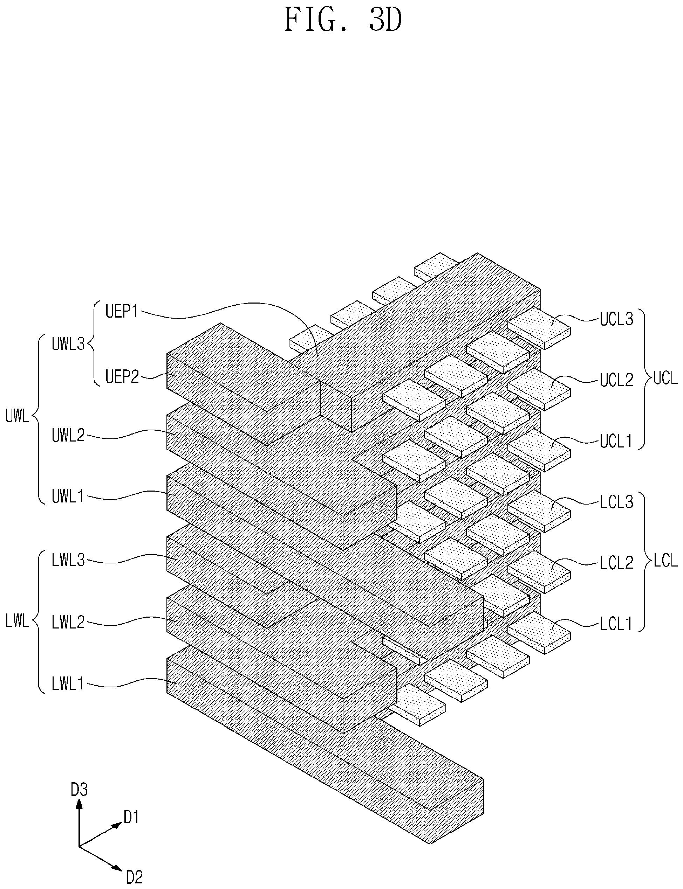

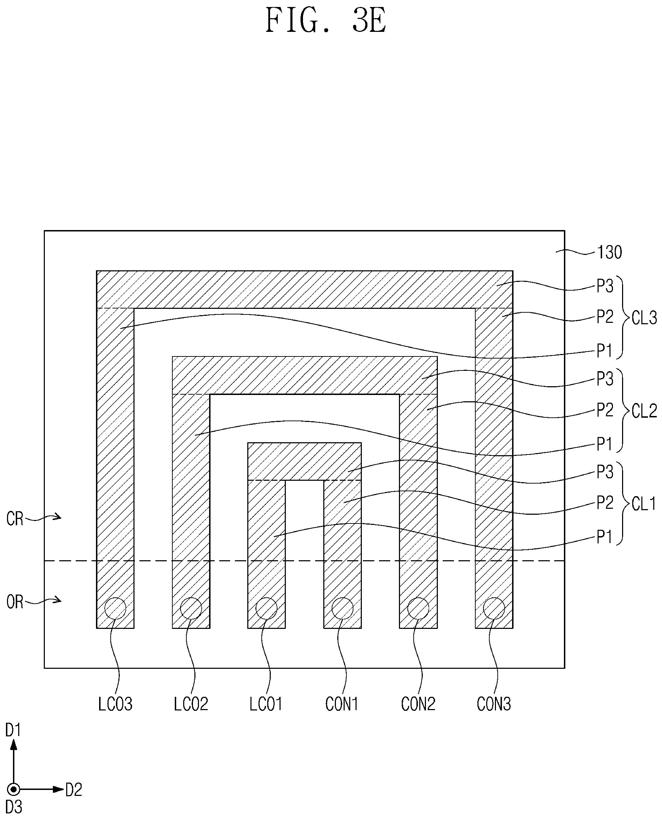

FIG. 3A is a plan view illustrating a semiconductor device according to an embodiment of the inventive concept. FIG. 3B is a sectional view taken along a line A-A' of FIG. 3A. FIG. 3C is a sectional view taken along a line B-B' of FIG. 3A. FIG. 3D is a perspective view illustrating word lines and channel layers. FIG. 3E is a plan view illustrating conductive connection lines.

Referring to FIGS. 3A, 3B, 3C, and 3D, the semiconductor device may include a substrate SUB. The substrate SUB may be a semiconductor substrate, an insulating substrate, a silicon-on-insulator (SOI) substrate, or a germanium-on-insulator (GOI) substrate. The semiconductor substrate may be, for example, a silicon substrate, a germanium substrate, or a silicon-germanium substrate. The substrate SUB may be a planar or plate-shaped structure that extends parallel to a plane defined by the first and second directions D1 and D2.

A lower insulating layer 110 may be provided on the substrate SUB. The lower insulating layer 110 may include an insulating material. In an embodiment, the lower insulating layer 110 may include a plurality of insulating layers. In an embodiment, peripheral transistors may be disposed between the substrate SUB and the lower insulating layer 110.

A lower stack LSS may be provided on the lower insulating layer 110. The lower stack LSS may include lower word lines LWL, lower channel layers LCL, gate insulating layers GI, intervening insulating patterns IIP, first capping patterns CP1, second capping patterns CP2, lower bit lines LBL, a lower data storing structure LDS, and a first cover insulating layer 120.

The lower data storing structure LDS may be provided on the lower insulating layer 110. The lower data storing structure LDS may be a capacitor, which includes first electrodes EL1, a second electrode EL2, and capacitor insulating layers CI. The first electrodes EL1 may be spaced apart from the second electrode EL2. The capacitor insulating layers CI may be provided between the first electrodes EL1 and the second electrode EL2.

The first electrodes EL1 may be provided at both (e.g., opposing) sides of the second electrode EL2. The capacitor insulating layers CI may be provided at both sides of the second electrode EL2. The first and second electrodes EL1 and EL2 may include a conductive material. The capacitor insulating layer CI may include an insulating material.

In an embodiment, the lower data storing structure LDS may be a variable resistance pattern whose resistance can be switched to one of at least two states by an electric pulse applied thereto. For example, the lower data storing structure LDS may be formed of or include at least one of phase-change materials whose crystal state can be changed depending on an amount of a current applied thereto, perovskite compounds, transition metal oxides, magnetic materials, ferromagnetic materials, or antiferromagnetic materials.

The lower bit lines LBL may be provided on the lower insulating layer 110. The lower bit lines LBL may extend in the third direction D3. The term "extend" may refer to a longitudinal direction of extension in some instances. The lower bit lines LBL may be provided at both sides of the lower data storing structure LDS. The lower data storing structure LDS may be disposed between the lower bit lines LBL. The lower bit lines LBL, which are arranged along one side of the lower data storing structure LDS, may be spaced apart from each other in the first direction D1. The lower bit lines LBL may include a conductive material.

The lower word lines LWL may be provided between the lower bit line LBL and the lower data storing structure LDS. The lower word lines LWL may be disposed at both sides of the lower data storing structure LDS. The lower data storing structure LDS may be disposed between the lower word lines LWL. The lower word lines LWL may include a first lower word line LWL1, a second lower word line LWL2, and a third lower word line LWL3, which are disposed at one side of the lower data storing structure LDS. The lower word lines LWL may include a conductive material.

The number of the lower word lines LWL included in the lower stack LSS is not limited to the illustrated example. In an embodiment, the number of the lower word lines LWL may be equal to or less than 2 or may be equal to or greater than 4.

The first to third lower word lines LWL1, LWL2, and LWL3 may be vertically stacked and overlapped with each other in the third direction D3, which may also be referred to herein as vertical overlap. More generally, components or layers described with reference to "overlap" in a particular direction may be at least partially obstructed by one another when viewed along a line extending in the particular direction or in a plane perpendicular to the particular direction. The second lower word line LWL2 may be disposed at a level that is higher than the first lower word line LWL1. The terms "level" and "higher" (or "lower") as used herein may refer to the relative distance of an element or layer with respect to a reference element or layer, such as the substrate SUB. A distance, in the third direction D3, between the second lower word line LWL2 and the substrate SUB may be larger than a distance, in the third direction D3, between the first lower word line LWL1 and the substrate SUB. The third lower word line LWL3 may be disposed at a level that is higher than the second lower word line LWL2.

The lower channel layers LCL may electrically connect the lower bit line LBL to the lower data storing structure LDS. The lower channel layers LCL may extend in the second direction D2. Each of the lower channel layers LCL may include a first source/drain region SD1, a channel region CH, and a second source/drain region SD2. The first source/drain region SD1 may be connected to the lower bit line LBL. The second source/drain region SD2 may be connected to a corresponding first electrode EL1 of the lower data storing structure LDS. The channel region CH may be disposed between the first source/drain region SD1 and the second source/drain region SD2.

The lower channel layer LCL may include at least one of a single crystalline semiconductor material, a polycrystalline semiconductor material, an oxide semiconductor material, or a two-dimensional material. The single crystalline semiconductor material may be, for example, single crystalline silicon. The polycrystalline semiconductor material may be, for example, polysilicon. The oxide semiconductor material may be, for example, indium gallium zinc oxide (IGZO). The two-dimensional material may be, for example, MoS₂, WS₂, MoSe₂, or WSe₂. The first and second source/drain regions SD1 and SD2 may be doped with impurities.

The lower channel layers LCL may include first lower channel layers LCL1 at least partially enclosed by the first lower word line LWL1, second lower channel layers LCL2 at least partially enclosed by the second lower word line LWL2, and third lower channel layers LCL3 at least partially enclosed by the third lower word line LWL3. The first to third lower channel layers LCL1, LCL2, and LCL3, which are connected to one of the lower bit lines LBL, may be overlapped with each other in the third direction D3.

The second lower channel layers LCL2 may be disposed at a level higher than the first lower channel layers LCL1. The third lower channel layers LCL3 may be disposed at a level higher than the second lower channel layers LCL2. The first lower channel layers LCL1 may be spaced apart from each other in the first direction D1. The second lower channel layers LCL2 may be spaced apart from each other in the first direction D1. The third lower channel layers LCL3 may be spaced apart from each other in the first direction D1.

At least a portion of the gate insulating layer GI of the lower stack LSS may be provided between the lower word line LWL and the lower channel layer LCL. The lower word line LWL and the lower channel layer LCL may be spaced apart from each other by the gate insulating layer GI of the lower stack LSS. The gate insulating layer GI of the lower stack LSS may include an insulating material.

The first capping pattern CP1 of the lower stack LSS may be provided between the lower word line LWL and the lower bit line LBL. The lower word line LWL and the lower bit line LBL may be spaced apart from each other by the first capping pattern CP1 of the lower stack LSS. The first capping pattern CP1 of the lower stack LSS may include an insulating material.

The second capping pattern CP2 of the lower stack LSS may be provided between the lower word line LWL and the lower data storing structure LDS. The lower word line LWL and the lower data storing structure LDS may be spaced apart from each other by the second capping pattern CP2 of the lower stack LSS. The second capping pattern CP2 of the lower stack LSS may include an insulating material.

The semiconductor device may include a cell region CR, in which the lower bit lines LBL, the lower data storing structure LDS, and the lower channel layers LCL are disposed, and a connection region OR, which is connected to the cell region CR.

Each of the lower word lines LWL may include a first lower electrode portion LEP1, which is disposed in the cell region CR, and a second lower electrode portion LEP2, which is disposed in the connection region OR.

The first lower electrode portion LEP1 may extend in the first direction D1. The first lower electrode portion LEP1 may be provided to at least partially enclose the lower channel layers LCL. The lower channel layer LCL may extend in the second direction D2 to penetrate or laterally extend beyond the first lower electrode portion LEP1. The first lower electrode portions LEP1 of the first to third lower word lines LWL1, LWL2, and LWL3 may be overlapped with each other in the third direction D3.

The second lower electrode portion LEP2 may extend in the second direction D2. The second lower electrode portions LEP2 of the first to third lower word lines LWL1, LWL2, and LWL3 may be overlapped with each other in the third direction D3. When measured in the second direction D2, a length L1 of the second lower electrode portion LEP2 of the first lower word line LWL1 may be larger than a length L2 of the second lower electrode portion LEP2 of the second lower word line LWL2. When measured in the second direction D2, the length L2 of the second lower electrode portion LEP2 of the second lower word line LWL2 may be larger than a length L3 of the second lower electrode portion LEP2 of the third lower word line LWL3. That is, the length in the second direction D2 of the second lower electrode portions LEP2 may decrease up the lower stack LSS (e.g. in order ascending up the lower stack LSS in the third direction D3).

The intervening insulating pattern IIP of the lower stack LSS may be provided between the lower word lines LWL. The intervening insulating pattern IIP of the lower stack LSS may be provided between the first electrodes EL1 of the lower data storing structure LDS. The intervening insulating pattern IIP of the lower stack LSS may include an insulating material.

The first cover insulating layer 120 may at least partially enclose the lower bit lines LBL, the lower word lines LWL, the lower data storing structure LDS, and the lower channel layers LCL. The first cover insulating layer 120 may include an insulating material. In an embodiment, the first cover insulating layer 120 may include a plurality of insulating layers.

An interlayer insulating layer 130 is provided on the lower stack LSS. The interlayer insulating layer 130 may include an insulating material. In an embodiment, the interlayer insulating layer 130 may include a plurality of insulating layers.

A lower bit line contact LBC, a lower data contact LDC, a lower bit line connection line LBO, a lower data connection line LDO, a first conductive connection line CL1, a second conductive connection line CL2, and a third conductive connection line CL3 may be provided in the interlayer insulating layer 130. Each of the lower bit line contact LBC, the lower data contact LDC, the lower bit line connection line LBO, the lower data connection line LDO, the first conductive connection line CL1, the second conductive connection line CL2, and the third conductive connection line CL3 may include a conductive material. In an embodiment, the lower bit line connection line LBO, the lower data connection line LDO, the first conductive connection line CL1, the second conductive connection line CL2, and the third conductive connection line CL3 may be disposed at the same level (e.g. the same level along the third direction D3), e.g., may be coplanar.

The lower bit line contact LBC may be connected to the lower bit line LBL. The lower bit line connection line LBO may be connected to the lower bit line contact LBC. The lower data contact LDC may be connected to the lower data storing structure LDS (e.g. to the second electrode EL2 of the lower data storing structure LDS). The lower data connection line LDO may be connected to the lower data contact LDC.

A first lower connection contact LCO1 may be provided to connect the second lower electrode portion LEP2 of the first lower word line LWL1 to the first conductive connection line CL1, a second lower connection contact LCO2 may be provided to connect the second lower electrode portion LEP2 of the second lower word line LWL2 to the second conductive connection line CL2, and a third lower connection contact LCO3 may be provided to connect the second lower electrode portion LEP2 of the third lower word line LWL3 to the third conductive connection line CL3. That is, for each lower word line, a respective lower connection contact may be provided to connect a respective second lower electrode portion to a respective conductive connection line. The first to third lower connection contacts LCO1, LCO2, and LCO3 may extend in the third direction D3. The first to third lower connection contacts LCO1, LCO2, and LCO3 may extend through the interlayer insulating layer 130 and the first cover insulating layer 120. Each of the first to third lower connection contacts LCO1, LCO2, and LCO3 may include a conductive material.

An upper stack USS is provided on the interlayer insulating layer 130. The upper stack USS may include upper word lines UWL, upper channel layers UCL, gate insulating layers GI, intervening insulating patterns IIP, first capping patterns CP1, second capping patterns CP2, upper bit lines UBL, an upper data storing structure UDS, and a second cover insulating layer 140.

The semiconductor device is illustrated to include two stacks (i.e., the lower and upper stacks LSS and USS), but the inventive concept is not limited to this example. In an embodiment, the semiconductor device may include a first stack, a second stack on the first stack, and a third stack on the second stack. The semiconductor device may include conductive connection lines between the first and second stacks and conductive connection lines between the second and third stacks. In an embodiment, the semiconductor device may include four or more stacks.

The upper data storing structure UDS may be provided on the interlayer insulating layer 130. The upper data storing structure UDS may be overlapped with the lower data storing structure LDS in the third direction D3. The upper data storing structure UDS may be a capacitor including the first electrodes EL1, the second electrode EL2, and the capacitor insulating layers CI.

In an embodiment, the upper data storing structure UDS may be a variable resistance pattern whose resistance state can be switched to one of two states by an electric pulse applied thereto.

The upper bit lines UBL may be provided on the interlayer insulating layer 130. The upper bit lines UBL may extend in the third direction D3. The upper bit line UBL may be overlapped with the lower bit line LBL in the third direction D3. The upper bit lines UBL may include a conductive material.

The upper word lines UWL may be provided between the upper bit line UBL and the upper data storing structure UDS. The upper word lines UWL may be overlapped with the lower word lines LWL in the third direction D3. The upper word lines UWL may include a first upper word line UWL1, a second upper word line UWL2, and a third upper word line UWL3, which are disposed at one side of the upper data storing structure UDS. The upper word lines UWL may include a conductive material.

The first to third upper word lines UWL1, UWL2, and UWL3 may be overlapped with the first to third lower word lines LWL1, LWL2, and LWL3 in the third direction D3. The second upper word line UWL2 may be disposed at a level higher than the first upper word line UWL1. The third upper word line UWL3 may be disposed at a level higher than the second upper word line UWL2.

The upper channel layers UCL may electrically connect the upper bit line UBL to the upper data storing structure UDS. The upper channel layer UCL may extend in the second direction D2. Each of the upper channel layers UCL may include the first source/drain region SD1, the channel region CH, and the second source/drain region SD2. The upper channel layer UCL may be formed of or include at least one of a single-crystalline semiconductor material, a poly-crystalline semiconductor material, an oxide semiconductor material, or a two-dimensional material.

The upper channel layers UCL may include first upper channel layers UCL1 at least partially enclosed by the first upper word line UWL1, second upper channel layers UCL2 at least partially enclosed by the second upper word line UWL2, and third upper channel layers UCL3 at least partially enclosed by the third upper word line UWL3.

At least a portion of the gate insulating layer GI of the upper stack USS may be provided between the upper word line UWL and the upper channel layer UCL. The upper word line UWL and the upper channel layer UCL may be spaced apart from each other by the gate insulating layer GI of the upper stack USS. The gate insulating layer GI of the upper stack USS may include an insulating material.

The first capping pattern CP1 of the upper stack USS may be provided between the upper word line UWL and the upper bit line UBL. The upper word line UWL and the upper bit line UBL may be spaced apart from each other by the first capping pattern CP1 of the upper stack USS. The first capping pattern CP1 of the upper stack USS may include an insulating material.

The second capping pattern CP2 of the upper stack USS may be provided between the upper word line UWL and the upper data storing structure UDS. The upper word line UWL and the upper data storing structure UDS may be spaced apart from each other by the second capping pattern CP2 of the upper stack USS. The second capping pattern CP2 of the upper stack USS may include an insulating material.

The upper bit lines UBL, the upper data storing structure UDS, and the upper channel layers UCL may be disposed in the cell region CR. Each of the upper word lines UWL may include a first upper electrode portion UEP1, which is disposed in the cell region CR, and a second upper electrode portion UEP2, which is disposed in the connection region OR.

The first upper electrode portion UEP1 may extend in the first direction D1. The first upper electrode portion UEP1 may be provided to at least partially enclose the upper channel layers UCL. The upper channel layer UCL may extend in the second direction D2 to penetrate the first upper electrode portion UEP1. The terms "enclose" and "penetrate" as used herein may not require complete enclosure or penetration. The first upper electrode portions UEP1 of the first to third upper word lines UWL1, UWL2, and UWL3 may be overlapped with each other in the third direction D3.

The second upper electrode portion UEP2 may extend in the second direction D2. The second upper electrode portions UEP2 of the first to third upper word lines UWL1, UWL2, and UWL3 may be overlapped with each other in the third direction D3. When measured in the second direction D2, a length L4 of the second upper electrode portion UEP2 of the first upper word line UWL1 may be larger than a length L5 of the second upper electrode portion UEP2 of the second upper word line UWL2 and the length L2 of the second lower electrode portion LEP2 of the second lower word line LWL2. When measured in the second direction D2, the length L5 of the second upper electrode portion UEP2 of the second upper word line UWL2 may be larger than a length L6 of the second upper electrode portion UEP2 of the third upper word line UWL3 and the length L3 of the second lower electrode portion LEP2 of the third lower word line LWL3. That is, the length in the second direction D2 of the second upper electrode portions UEP2 may decrease up the upper stack USS (e.g. in order ascending up the upper stack USS in the third direction D3).

The intervening insulating pattern IIP of the upper stack USS may be provided between the upper word lines UWL. The intervening insulating pattern IIP of the upper stack USS may be provided between the first electrodes EL1 of the upper data storing structure UDS. The intervening insulating pattern IIP of the upper stack USS may include an insulating material.

The second cover insulating layer 140 may at least partially enclose the upper bit lines UBL, the upper word lines UWL, the upper data storing structure UDS, and the upper channel layers UCL. The second cover insulating layer 140 may include an insulating material. In an embodiment, the second cover insulating layer 140 may include a plurality of insulating layers.

An upper insulating layer 150 may be provided on the upper stack USS. The upper insulating layer 150 may include an insulating material. In an embodiment, the upper insulating layer 150 may include a plurality of insulating layers.

An upper bit line contact UBC, an upper data contact UDC, an upper bit line connection line UBO, an upper data connection line UDO, a first upper conductive line UL1, a second upper conductive line UL2, a third upper conductive line UL3, a fourth upper conductive line UL4, a fifth upper conductive line UL5, and a sixth upper conductive line UL6 may be provided in the upper insulating layer 150. Each of the upper bit line contact UBC, the upper data contact UDC, the upper bit line connection line UBO, the upper data connection line UDO, the first upper conductive line UL1, the second upper conductive line UL2, the third upper conductive line UL3, the fourth upper conductive line UL4, the fifth upper conductive line UL5, and the sixth upper conductive line UL6 may include a conductive material. In an embodiment, the upper bit line connection line UBO, the upper data connection line UDO, the first upper conductive line UL1, the second upper conductive line UL2, the third upper conductive line UL3, the fourth upper conductive line UL4, the fifth upper conductive line UL5, and the sixth upper conductive line UL6 may be disposed at the same level.

The upper bit line contact UBC may be connected to the upper bit line UBL. The upper bit line connection line UBO may be connected to the upper bit line contact UBC. The upper data contact UDC may be connected to the upper data storing structure UDS (e.g. the second electrode EL2 of the upper data storing structure UDS). The upper data connection line UDO may be connected to the upper data contact UDC.

A first penetration contact CON1 may be provided to connect the first upper conductive line UL1 to the first conductive connection line CL1, a second penetration contact CON2 may be provided to connect the second upper conductive line UL2 to the second conductive connection line CL2, a third penetration contact CON3 may be provided to connect the third upper conductive line UL3 to the third conductive connection line CL3, a first upper connection contact UCO1 may be provided to connect the fourth upper conductive line UL4 to the second upper electrode portion UEP2 of the first upper word line UWL1, a second upper connection contact UCO2 may be provided to connect the fifth upper conductive line UL5 to the second upper electrode portion UEP2 of the second upper word line UWL2, and a third upper connection contact UCO3 may be provided to connect the sixth upper conductive line UL6 to the second upper electrode portion UEP2 of the third upper word line UWL3. That is, for each upper word line, a respective upper connection contact may be provided to connect a respective second upper electrode portion to a respective upper conductive connection line. Similarly, for each conductive connection line, a respective penetration contact may be provided to connect a respective upper conductive line to the conductive connection line.

The first to third upper connection contacts UCO1, UCO2, and UCO3 and the first to third penetration contacts CON1, CON2, and CON3 may extend in the third direction D3. The first to third upper connection contacts UCO1, UCO2, and UCO3 may extend through the upper insulating layer 150 and the second cover insulating layer 140. The first to third penetration contacts CON1, CON2, and CON3 are provided to penetrate the upper stack USS. The first to third penetration contacts CON1, CON2, and CON3 may extend through the upper insulating layer 150, the second cover insulating layer 140, and the interlayer insulating layer 130. Each of the first to third upper connection contacts UCO1, UCO2, and UCO3 and each of the first to third penetration contacts CON1, CON2, and CON3 may include a conductive material.

The first lower word line LWL1 may be electrically connected to the first upper conductive line UL1 through the first lower connection contact LCO1, the first conductive connection line CL1, and the first penetration contact CON1. The second lower word line LWL2 may be electrically connected to the second upper conductive line UL2 through the second lower connection contact LCO2, the second conductive connection line CL2, and the second penetration contact CON2. The third lower word line LWL3 may be electrically connected to the third upper conductive line UL3 through the third lower connection contact LCO3, the third conductive connection line CL3, and the third penetration contact CON3.

The first upper word line UWL1 may be electrically connected to the fourth upper conductive line UL4 through the first upper connection contact UCO1. The second upper word line UWL2 may be electrically connected to the fifth upper conductive line UL5 through the second upper connection contact UCO2. The third upper word line UWL3 may be electrically connected to the sixth upper conductive line UL6 through the third upper connection contact UCO3.

The first to third lower connection contacts LCO1, LCO2, and LCO3, the first to third penetration contacts CON1, CON2, and CON3, and the first to third upper connection contacts UCO1, UCO2, and UCO3 may be disposed in the connection region OR.

Referring to FIGS. 3B, 3C, and 3E, each of the first to third conductive connection lines CL1, CL2, and CL3 may include a first portion P1 and a second portion P2, which are extended in the first direction D1, and a third portion P3, which extends in the second direction D2. The third portion P3 may connect the first portion P1 to the second portion P2.

A bottom surface of the first portion P1 of the first conductive connection line CL1 may be in contact with a top surface of the first lower connection contact LCO1. A bottom surface of the first portion P1 of the second conductive connection line CL2 may be in contact with a top surface of the second lower connection contact LCO2. A bottom surface of the first portion P1 of the third conductive connection line CL3 may be in contact with a top surface of the third lower connection contact LCO3. A top surface of the second portion P2 of the first conductive connection line CL1 may be in contact with a bottom surface of the first penetration contact CON1. A top surface of the second portion P2 of the second conductive connection line CL2 may be in contact with a bottom surface of the second penetration contact CON2. A top surface of the second portion P2 of the third conductive connection line CL3 may be in contact with a bottom surface of the third penetration contact CON3.

The first portions P1 of the first to third conductive connection lines CL1, CL2, and CL3 may be overlapped with the second upper electrode portion UEP2 of the first upper word line UWL1 and the second lower electrode portion LEP2 of the first lower word line LWL1 in the third direction D3.

The first portions P1 of the second and third conductive connection lines CL2 and CL3 may be overlapped with the second upper electrode portion UEP2 of the second upper word line UWL2 and the second lower electrode portion LEP2 of the second lower word line LWL2 in the third direction D3. The first portion P1 of the first conductive connection line CL1 may not be overlapped with the second upper electrode portion UEP2 of the second upper word line UWL2 and the second lower electrode portion LEP2 of the second lower word line LWL2 in the third direction D3.

The first portion P1 of the third conductive connection line CL3 may be overlapped with the second upper electrode portion UEP2 of the third upper word line UWL3 and the second lower electrode portion LEP2 of the third lower word line LWL3 in the third direction D3. The first portions P1 of the first and second conductive connection line CL1 and CL2 may not be overlapped with the second upper electrode portion UEP2 of the third upper word line UWL3 and the second lower electrode portion LEP2 of the third lower word line LWL3 in the third direction D3.

The first conductive connection line CL1 may be disposed between the first and second portions P1 and P2 of the second conductive connection line CL2. The first and second conductive connection lines CL1 and CL2 may be disposed between the first and second portions P1 and P2 of the third conductive connection line CL3.

The first to third lower connection contacts LCO1, LCO2, and LCO3 and the first to third upper connection contacts UCO1, UCO2, and UCO3 may be overlapped with the second upper electrode portion UEP2 of the first upper word line UWL1 and the second lower electrode portion LEP2 of the first lower word line LWL1 in the third direction D3.

The second and third lower connection contacts LCO2 and LCO3 and the second and third upper connection contacts UCO2 and UCO3 may be overlapped with the second upper electrode portion UEP2 of the second upper word line UWL2 and the second lower electrode portion LEP2 of the second lower word line LWL2 in the third direction D3. The first lower connection contact LCO1 and the first upper connection contact UCO1 may not be overlapped with the second upper electrode portion UEP2 of the second upper word line UWL2 and the second lower electrode portion LEP2 of the second lower word line LWL2 in the third direction D3.

The third lower connection contact LCO3 and the third upper connection contact UCO3 may be overlapped with the second upper electrode portion UEP2 of the third upper word line UWL3 and the second lower electrode portion LEP2 of the third lower word line LWL3 in the third direction D3. The first and second lower connection contacts LCO1 and LCO2 and the first and second upper connection contacts UCO1 and UCO2 may not be overlapped with the second upper electrode portion UEP2 of the third upper word line UWL3 and the second lower electrode portion LEP2 of the third lower word line LWL3 in the third direction D3.

The first to third penetration contacts CON1, CON2, and CON3 may not be overlapped with the upper word lines UWL and the lower word lines LWL in the third direction D3. The second portions P2 of the first to third conductive connection lines CL1, CL2, and CL3 may not be overlapped with the upper word lines UWL and the lower word lines LWL in the third direction D3.

In an embodiment, the first lower connection contact LCO1 and the first upper connection contact UCO1 may be overlapped with each other in the third direction D3.

A length of the second conductive connection line CL2 may be larger than a length of the first conductive connection line CL1. A length of the third conductive connection line CL3 may be larger than the length of the second conductive connection line CL2. For example, two or more the first, second, and third conductive connections lines CL1, CL2, and CL3 may be arranged in a nested configuration in plan view.

When measured in the first direction D1, lengths of the first and second portions P1 and P2 of the first conductive connection line CL1 may be smaller than lengths of the first and second portions P1 and P2 of the second conductive connection line CL2. When measured in the first direction D1, the lengths of the first and second portions P1 and P2 of the second conductive connection line CL2 may be smaller than lengths of the first and second portions P1 and P2 of the third conductive connection line CL3.

A length of the third portion P3 of the first conductive connection line CL1 in the second direction D2 may be smaller than a length of the third portion P3 of the second conductive connection line CL2 in the second direction D2. The length of the third portion P3 of the second conductive connection line CL2 in the second direction D2 may be smaller than a length of the third portion P3 of the third conductive connection line CL3 in the second direction D2.

The third portions P3 of the first to third conductive connection lines CL1, CL2, and CL3 may be disposed in the cell region CR. The first and second portions P1 and P2 of the first to third conductive connection lines CL1, CL2, and CL3 may extend from the cell region CR to the connection region OR.

In an embodiment, the first conductive connection line CL1 may have a linear or line shape extending in the second direction D2.

A length of the first lower connection contact LCO1 in the third direction D3 may be larger than a length of the second lower connection contact LCO2 in the third direction D3. The length of the second lower connection contact LCO2 in the third direction D3 may be larger than a length of the third lower connection contact LCO3 in the third direction D3. A length of the first upper connection contact UCO1 in the third direction D3 may be larger than a length of the second upper connection contact UCO2 in the third direction D3. The length of the second upper connection contact UCO2 in the third direction D3 may be larger than a length of the third upper connection contact UCO3 in the third direction D3. The lengths of the first to third penetration contacts CON1, CON2, and CON3 in the third direction D3 may be larger than the lengths of the first to third lower connection contacts LCO1, LCO2, and LCO3 and the first to third upper connection contacts UCO1, UCO2, and UCO3 in the third direction D3. In an embodiment, the lengths of the first to third penetration contacts CON1, CON2, and CON3 in the third direction D3 may be substantially the same.

In an embodiment, the first to third conductive connection lines CL1, CL2, and CL3 may be overlapped with at least one of the upper channel layer UCL, the lower channel layer LCL, the upper data storing structure UDS, or the lower data storing structure LDS in the third direction D3.

When measured in the second direction D2, a distance (i.e., a lateral distance) between the first lower connection contact LCO1 and the first penetration contact CON1 may be smaller than a distance between the second lower connection contact LCO2 and the first penetration contact CON1. When measured in the second direction D2, a distance between the first penetration contact CON1 and the second upper electrode portion UEP2 of the first upper word line UWL1 may be smaller than a distance between the first penetration contact CON1 and the first upper connection contact UCO1 and a distance between the first penetration contact CON1 and the first lower connection contact LCO1.

According to an embodiment of the inventive concept, since the semiconductor device includes the interlayer insulating layer and the conductive connection line, the lower word line, which is overlapped with the upper word line, may be electrically connected to the upper conductive line. Thus, it may be possible to reduce or minimize an occupying area of the connection region and to reduce a size of the semiconductor device. Furthermore, it may be possible to increase a degree of freedom of an interconnection structure of the semiconductor device and to reduce technical difficulties in fabricating the semiconductor device.

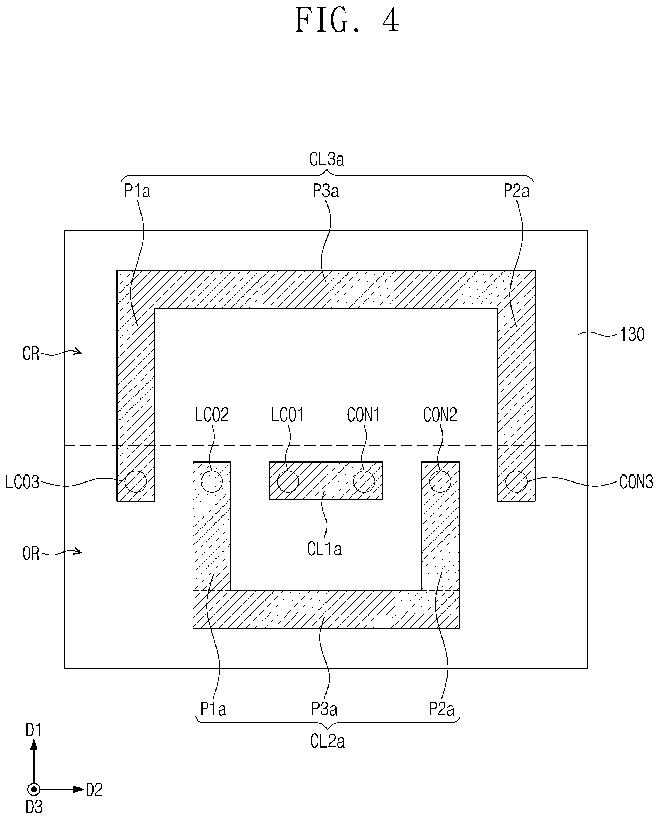

FIG. 4 is a plan view illustrating conductive connection lines of a semiconductor device according to an embodiment of the inventive concept. The semiconductor device of FIG. 4 may be similar to the semiconductor device described with reference to FIGS. 3A to 3E, except for some features described below.

Referring to FIG. 4, a first conductive connection line CL1a may have a line or bar shape extending in the second direction D2. The first conductive connection line CL1a may be disposed in the connection region OR. A second conductive connection line CL2a may be disposed in the connection region OR and may include a first portion P1a, a second portion P2a, and a third portion P3a. A third portion P3a of a third conductive connection line CL3a may be disposed in the cell region CR. The first and second portions P1a and P2a of the third conductive connection line CL3a may extend from the cell region CR to the connection region OR.

The first conductive connection line CL1a may be disposed between the third portion P3a of the second conductive connection line CL2a and the third portion P3a of the third conductive connection line CL3a. The first and second portions P1a and P2a of the second conductive connection line CL2a and the first and second portions P1a and P2a of the third conductive connection line CL3a may be disposed between the third portion P3a of the second conductive connection line CL2a and the third portion P3a of the third conductive connection line CL3a.

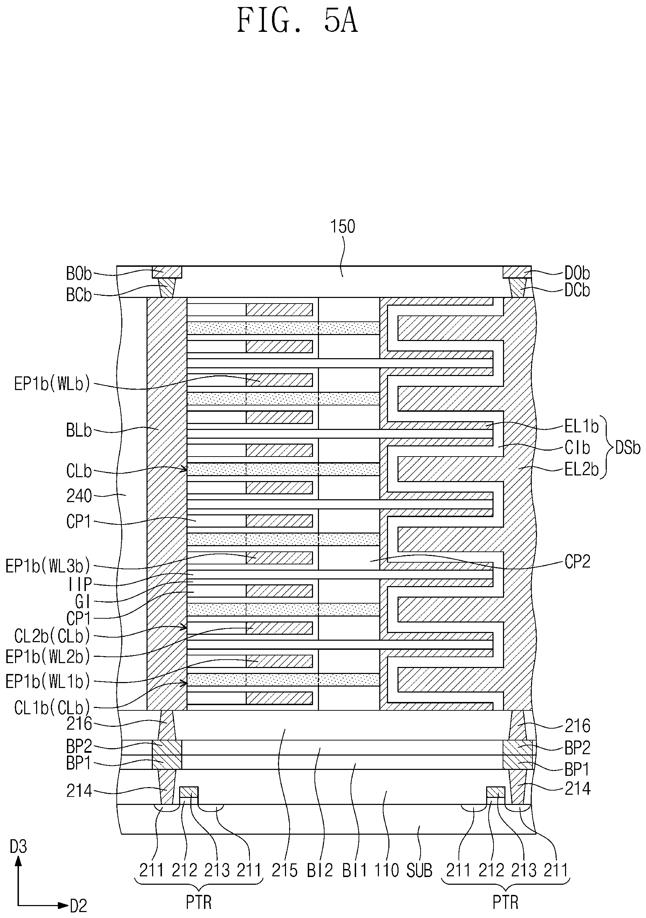

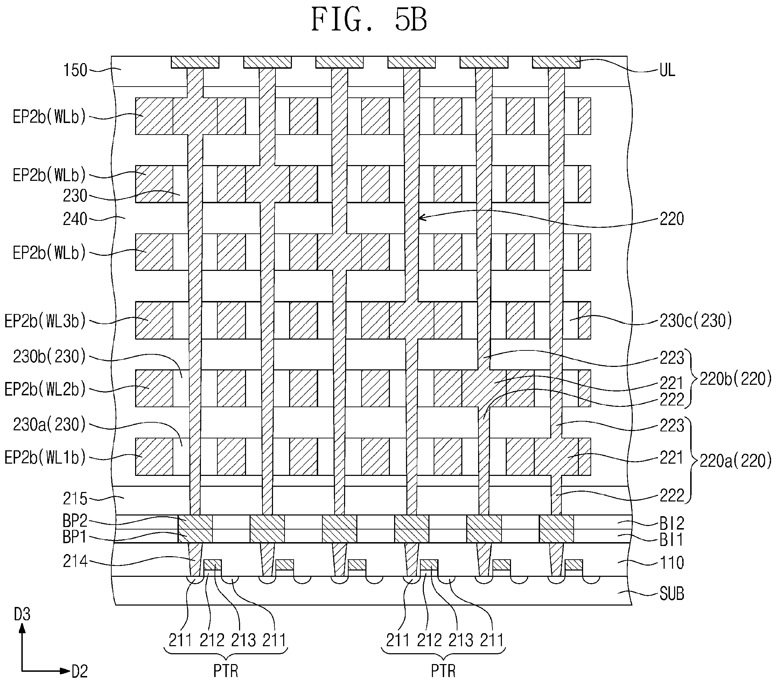

FIGS. 5A and 5B are sectional views illustrating a semiconductor device according to an embodiment of the inventive concept. The semiconductor device of FIGS. 5A and 5B may be similar to the semiconductor device described with reference to FIGS. 3A to 3E, except for some features described below.

Referring to FIGS. 5A and 5B, peripheral transistors PTR may be provided between the substrate SUB and the lower insulating layer 110. The peripheral transistor PTR may include impurity regions 211, a peripheral gate insulating layer 212, and a peripheral gate electrode 213. The impurity regions 211 may be formed by doping the substrate SUB with impurities. The peripheral gate insulating layer 212 may include an insulating material. The peripheral gate electrode 213 may include a conductive material.

A first bonding insulating layer BI1 may be provided on the lower insulating layer 110. A second bonding insulating layer BI2 may be provided on the first bonding insulating layer BI1. A first cover insulating layer 215 may be provided on the second bonding insulating layer BI2. A second cover insulating layer 240 may be provided on the first cover insulating layer 215. The second cover insulating layer 240 may be provided to at least partially enclose bit lines BLb, channel layers CLb, word lines WLb, and a data storing structure DSb. The data storing structure DSb may include first electrodes EL1b, a capacitor insulating layer CIb and a second electrode EL2b. Each of the first bonding insulating layer BI1, the second bonding insulating layer BI2, the first cover insulating layer 215, and the second cover insulating layer 240 may include an insulating material.

First contacts 214 may be provided in the lower insulating layer 110. First bonding pads BP1 may be provided in the first bonding insulating layer BI1. Second bonding pads BP2 may be provided in the second bonding insulating layer BI2. Second contacts 216 may be provided in the first cover insulating layer 215. Each of the first contact 214, the second contact 216, the first bonding pad BP1, and the second bonding pad BP2 may include a conductive material.

The first bonding insulating layer BI1 and the first bonding pad BP1 may be bonded to the second bonding insulating layer BI2 and the second bonding pad BP2 in a hybrid bonding manner. The first bonding insulating layer BI1 may be bonded to the second bonding insulating layer BI2 through a wafer bonding process. The first bonding pad BP1 may be bonded to the second bonding pad BP2 through the wafer bonding process.

A bit line contact BCb, a bit line connection line BOb, a data contact DCb, a data connection line DOb, and upper conductive lines UL may be provided in the upper insulating layer 150.

The word line WLb may include a first electrode portion EP1b and a second electrode portion EP2b. Penetration insulating patterns 230 may be provided to penetrate the second electrode portion EP2b. The penetration insulating pattern 230 may have a ring shape. The penetration insulating pattern 230 may include an insulating material.

Connection contacts 220 may be provided. The connection contact 220 may connect the upper conductive line UL to the second bonding pad BP2. The connection contact 220 may extend through the upper insulating layer 150, the second cover insulating layer 240, and the first cover insulating layer 215. The connection contact 220 may extend in the third direction D3. The connection contact 220 may include a conductive material.

The connection contact 220 may include a connecting portion 221, a lower portion 222, and an upper portion 223. The connecting portion 221 may be provided between the lower and upper portions 222 and 223 of the connection contact 220. The connecting portion 221 of the connection contact 220 may be in contact with the second electrode portion EP2b. The lower portion 222 of the connection contact 220 may be in contact with the second bonding pad BP2. The upper portion 223 of the connection contact 220 may be in contact with the upper conductive line UL. At least one of the upper or lower portion 223 or 222 of the connection contact 220 may be provided to penetrate the penetration insulating pattern 230 and the word line WLb.

A width of the connecting portion 221 of the connection contact 220 may be larger than a width of the lower and upper portions 222 and 223 of the connection contact 220. In an embodiment, a width of the connecting portion 221 of the connection contact 220 in the second direction D2 may be larger than a width of the lower and upper portions 222 and 223 of the connection contact 220 in the second direction D2.

The bit line BLb may be electrically connected to the peripheral transistor PTR through the second contact 216, the second bonding pad BP2, the first bonding pad BP1, and the first contact 214. The bit line BLb may be electrically connected to the bit line connection line BOb through the bit line contact BCb.

The data storing structure DSb may be electrically connected to the peripheral transistor PTR through the second contact 216, the second bonding pad BP2, the first bonding pad BP1, and the first contact 214. The data storing structure DSb may be electrically connected to the data connection line DOb through the data contact DCb.

The word line WLb may be electrically connected to the upper conductive line UL through the connection contact 220. The word line WLb may be electrically connected to the peripheral transistor PTR through the connection contact 220, the second bonding pad BP2, the first bonding pad BP1, and the first contact 214.

The word lines WLb may include a first word line WL1b, a second word line WL2b on the first word line WL1b, and a third word line WL3b on the second word line WL2b. The channel layers CLb may include a first channel layer CL1b penetrating the first electrode portion EP1b of the first word line WL1b and a second channel layer CL2b penetrating the first electrode portion EP1b of the second word line WL2b. As used herein, a "penetrating" element or layer may be at least partially surrounded by (and in some instances, may extend into and beyond) the element or layer that is penetrated thereby. The penetration insulating patterns 230 may include first penetration insulating patterns 230a penetrating the second electrode portion EP2b of the first word line WL1b, second penetration insulating patterns 230b penetrating the second electrode portion EP2b of the second word line WL2b, and third penetration insulating patterns 230c penetrating the second electrode portion EP2b of the third word line WL3b.

The connection contacts 220 may include a first connection contact 220a, which is electrically connected to the first word line WL1b, and a second connection contact 220b, which is electrically connected to the second word line WL2b.

The upper portion 223 of the first connection contact 220a may be provided to penetrate the second electrode portion EP2b of the second word line WL2b, the second penetration insulating pattern 230b, the second electrode portion EP2b of the third word line WL3b, and the third penetration insulating pattern 230c. The lower portion 222 of the second connection contact 220b may be provided to penetrate the second electrode portion EP2b of the first word line WL1b and the first penetration insulating pattern 230a. The upper portion 223 of the second connection contact 220b may be provided to penetrate the second electrode portion EP2b of the third word line WL3b and the third penetration insulating pattern 230c. A thickness of the connecting portion 221 of the first connection contact 220a in the third direction D3 may be substantially equal to a thickness of the second electrode portion EP2b of the first word line WL1b in the third direction D3. A thickness of the first penetration insulating pattern 230a in the third direction D3 may be substantially equal to the thickness of the second electrode portion EP2b of the first word line WL1b in the third direction D3.

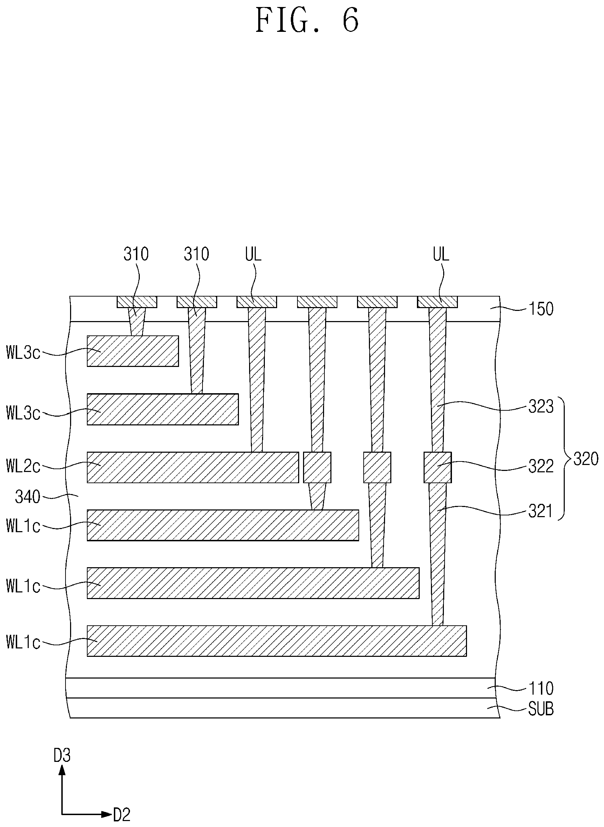

FIG. 6 is a sectional view illustrating a semiconductor device according to an embodiment of the inventive concept. The semiconductor device of FIG. 6 may be similar to the semiconductor device described with reference to FIGS. 3A to 3E, except for some features described below.

Referring to FIG. 6, the semiconductor device may include a cover insulating layer 340 on the lower insulating layer 110. First word lines WL1c, a second word line WL2c, and third word lines WL3c, which are at least partially enclosed by the cover insulating layer 340, may be provided. The second word line WL2c may be disposed on the first word lines WL1c. The third word lines WL3c may be disposed on the second word line WL2c.

First connection contacts 310 and second connection contacts 320 may be provided. Each of the third and second word lines WL3c and WL2c may be electrically connected to the upper conductive line UL through the first connection contact 310.

Each second connection contact 320 may include a lower contact 321, a conductive pattern 322, and an upper contact 323. The upper contacts 323 may have substantially the same height. The lower contacts 321 may have different heights from each other. The conductive patterns 322 may be disposed at the same level as or coplanar with the second word line WL2c. A thickness of the conductive pattern 322 in the third direction D3 may be substantially equal to a thickness of the second word line WL2c in the third direction D3. A width of the conductive pattern 322 (e.g., in the second direction D2) may be larger than a width of the upper contact 323 and a width of the lower contact 321.

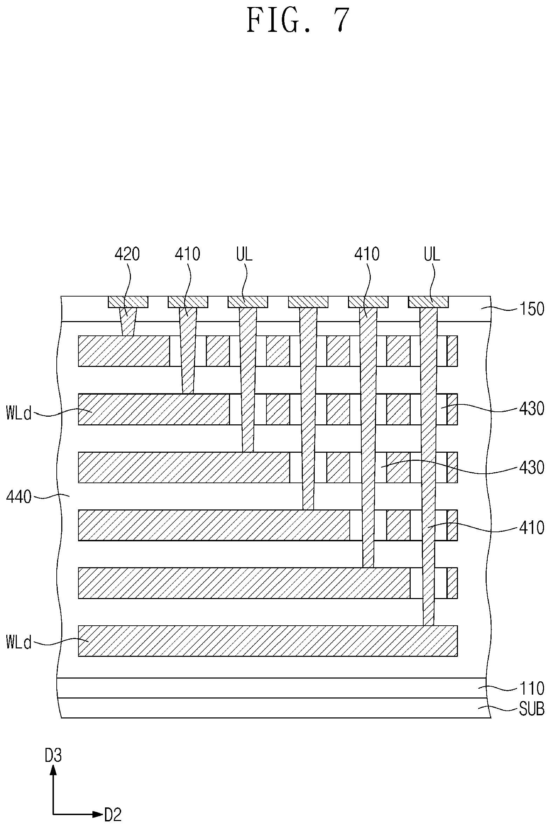

FIG. 7 is a sectional view illustrating a semiconductor device according to an embodiment of the inventive concept. The semiconductor device of FIG. 7 may be similar to the semiconductor device described with reference to FIGS. 3A to 3E, except for some features described below.

Referring to FIG. 7, the semiconductor device may include a cover insulating layer 440 on the lower insulating layer 110. Word lines WLd may be provided in and at least partially enclosed by the cover insulating layer 440. Penetration insulating patterns 430 may be provided to penetrate the word lines WLd.

First connection contacts 410 and a second connection contact 420 may be provided. The first connection contact 410 may be provided to penetrate at least one of the penetration insulating patterns 430 and at least one of the word lines WLd. Each first connection contact 410 may be electrically connected to a word line WLd. The second connection contact 420 may be electrically connected to the uppermost one of the word lines WLd. The second connection contact 420 may not penetrate the penetration insulating pattern 430 and the word line WLd.

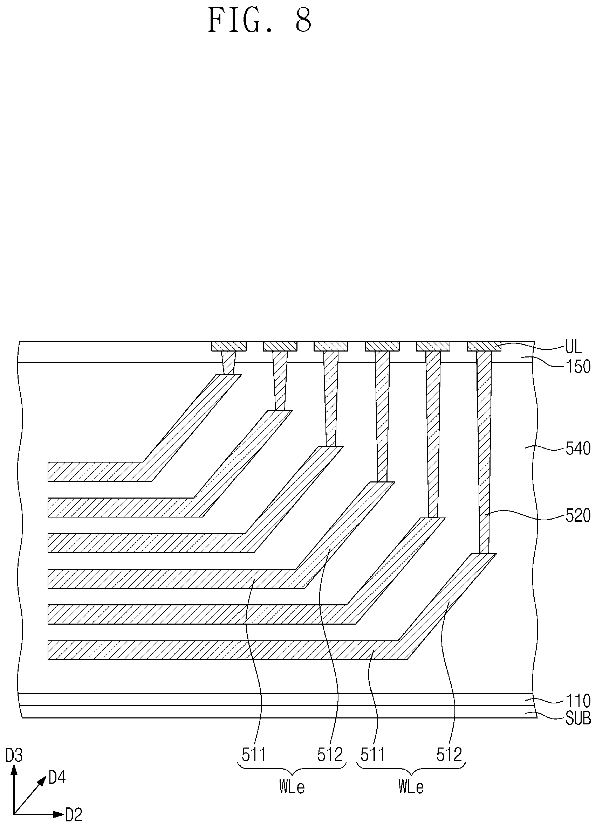

FIG. 8 is a sectional view illustrating a semiconductor device according to an embodiment of the inventive concept. The semiconductor device of FIG. 8 may be similar to the semiconductor device described with reference to FIGS. 3A to 3E, except for some features described below.

Referring to FIG. 8, the semiconductor device may include a cover insulating layer 540 on the lower insulating layer 110. Word lines WLe, which are at least partially enclosed by the cover insulating layer 540, may be provided.

Each word line WLe may include a first portion 511 and a second portion 512. The first portion 511 of the word line WLe may extend in the second direction D2. The second portion 512 of the word line WLe may extend in a fourth direction D4. The fourth direction D4 may not be parallel to the first direction D1, the second direction D2, and the third direction D3. The fourth direction D4 may not be parallel to the vertical and horizontal directions. For example, the fourth direction D4 may be inclined at an angle relative to the top surface of the substrate SUB.

The word line WLe may be electrically connected to the upper conductive line UL through a connection contact 520. The connection contact 520 may be in contact with the second portion 512 of the word line WLe.

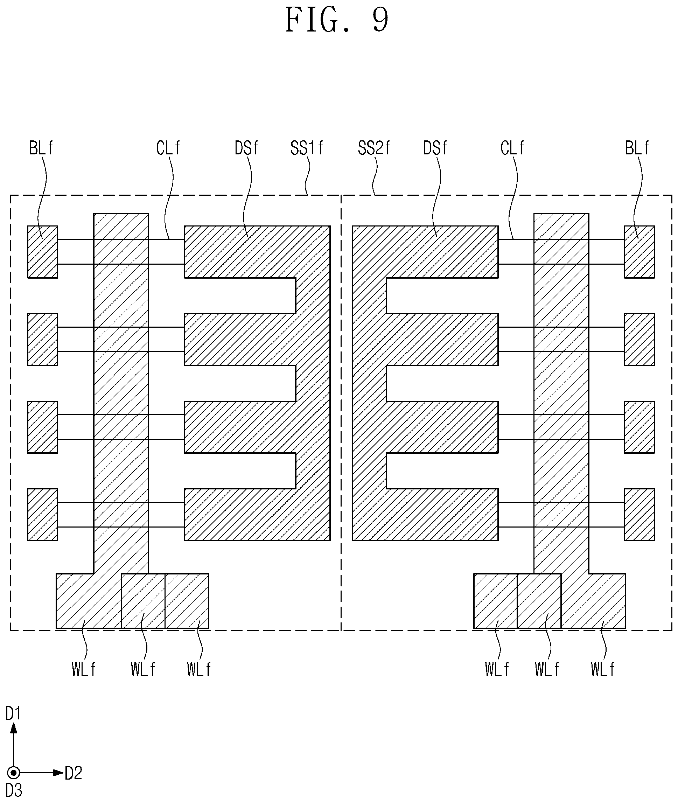

FIG. 9 is a plan view illustrating a semiconductor device according to an embodiment of the inventive concept. The semiconductor device of FIG. 9 may be similar to the semiconductor device described with reference to FIGS. 3A to 3E, except for some features described below.

Referring to FIG. 9, the semiconductor device may include a first stack SS1f and a second stack SS2f. The first stack SS1f and the second stack SS2f may be spaced apart from each other in the second direction D2. Each of the first and second stacks SS1f and SS2f may include a bit line BLf, a channel layer CLf, a data storing structure DSf, and a word line WLf. In an embodiment, the first and second stacks SS1f and SS2f may be provided to have mirror symmetry. The bit line BLf, the channel layer CLf, and the data storing structure DSf of the first stack SS1f may be sequentially arranged in the second direction D2. The bit line BLf, the channel layer CLf, and the data storing structure DSf of the second stack SS2f may be sequentially arranged in the opposite direction of the second direction D2. A distance, in the second direction D2, between the data storing structures DSf of the first and second stacks SS1f and SS2f may be smaller than a distance, in the second direction D2, between the data storing structure DSf of the first stack SS1f and the bit line BLf of the second stack SS2f.

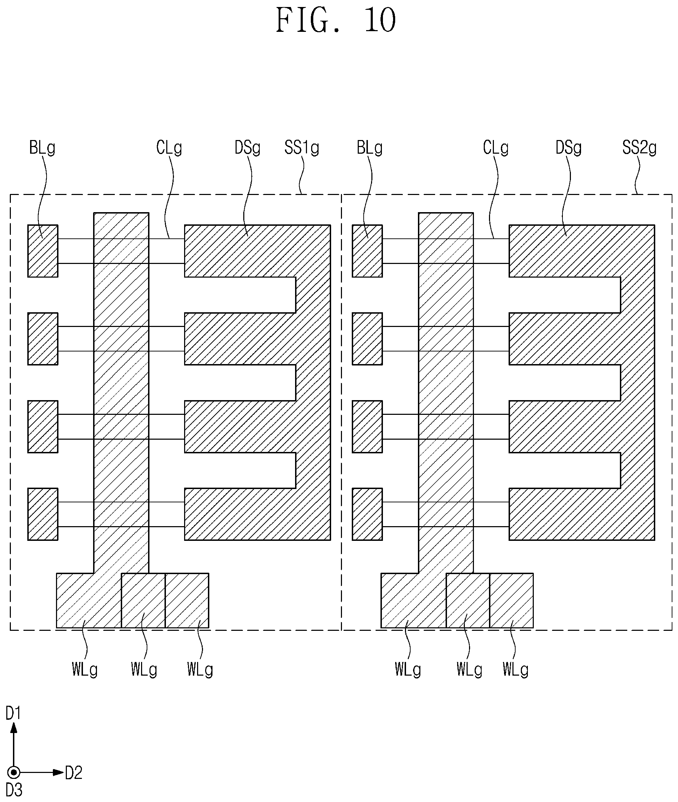

FIG. 10 is a plan view illustrating a semiconductor device according to an embodiment of the inventive concept. The semiconductor device of FIG. 10 may be similar to the semiconductor device described with reference to FIGS. 3A to 3E, except for some features described below.

Referring to FIG. 10, the semiconductor device may include a first stack SS1g and a second stack SS2g. The first stack SS1g and the second stack SS2g may be spaced apart from each other in the second direction D2. Each of the first and second stacks SS1g and SS2g may include a bit line BLg, a channel layer CLg, a data storing structure DSg, and a word line WLg. The bit line BLg, the channel layer CLg, and the data storing structure DSg of each of the first and second stacks SS1g and SS2g may be sequentially arranged in the second direction D2. A distance, in the second direction D2, between the data storing structures DSg of the first and second stacks SS1g and SS2g may be larger than a distance, in the second direction D2, between the data storing structure DSg of the first stack SS1g and the bit line BLg of the second stack SS2g.

According to an embodiment of the inventive concept, by reducing or minimizing an occupying area of a connection region, it may be possible to reduce a size of a semiconductor device.

While example embodiments of the inventive concept have been particularly shown and described, it will be understood by one of ordinary skill in the art that variations in form and detail may be made therein without departing from the scope of the attached claims.

## Claims

1. A semiconductor memory device, comprising:
a lower stack (LSS) including a first lower word line (LWL1), a first lower channel layer (LCL) at least partially surrounded by the first lower word line (LWL1), and a lower data storing structure (LDS) electrically connected to the first lower channel layer (LCL);
an interlayer insulating layer (130) on the lower stack (LSS); and
an upper stack (USS) on the interlayer insulating layer (130), the upper stack (USS) including an upper word line (UWL1), an upper channel layer (UCL) at least partially surrounded by the upper word line (UWL1), and an upper data storing structure (UDS) electrically connected to the upper channel layer (UCL);
a lower connection contact (LCO) on the first lower word line (LWL1);
a conductive connection line (CL) on the lower connection contact (LCO); and
a penetration contact (CON) on the conductive connection line (CL)
wherein the lower connection contact (LCO) vertically overlaps the upper word line (UWL1),
the penetration contact (CON) does not vertically overlap the upper word line (UWL1),
**characterized in that**:
the penetration contact (CON) penetrates the upper stack (USS) and is electrically connected to the first lower word line (LWL1) through the lower connection contact (LCO) and the conductive connection line (CL).

2. The semiconductor memory device of claim 1, wherein the conductive connection line comprises:
a first portion (P1) in contact with a top surface of the lower connection contact (LCO);
a second portion (P2) in contact with a bottom surface of the penetration contact (CON); and
a third portion (P3) connecting the first portion (P1) to the second portion (P2).

3. The semiconductor memory device of claim 2, wherein the first portion (P1) of the conductive connection line (CL) vertically overlaps the upper word line (UWL1), and
the second portion (P2) of the conductive connection line (CL) does not vertically overlap the upper word line (UWL1).

4. The semiconductor memory device of claim 2 or claim 3, wherein the third portion (P3) of the conductive connection line (CL), the first lower channel layer (LCL), and the upper channel layer (UCL) extend in a first direction, and
the first and second portions of the conductive connection line (CL) extend in a second direction intersecting the first direction.

5. The semiconductor memory device of any preceding claim, wherein the lower connection contact (LCO) and the penetration contact (CON) are spaced apart from each other in a horizontal direction.

6. The semiconductor memory device of any preceding claim, wherein the lower stack (LSS) further comprises:
a second lower word line stacked between the first lower word line (LWL1) and the interlayer insulating layer (130); and
a second lower channel layer (LCL) laterally extending beyond the second lower word line,
wherein the first lower word line (LWL1) comprises:
a first lower electrode portion at least partially enclosing the first lower channel layer (LCL); and
a second lower electrode portion in contact with the lower connection contact (LCO),
wherein the second lower word line comprises:
a first lower electrode portion vertically overlapping the first lower electrode portion of the first lower word line (LWL1); and
a second lower electrode portion vertically overlapping the second lower electrode portion of the first lower word line (LWL1),
wherein a length of the second lower electrode portion of the first lower word line (LWL1) is greater than a length of the second lower electrode portion of the second lower word line.

7. The semiconductor memory device of claim 6, wherein the upper word line (UWL1) comprises:
a first upper electrode portion vertically overlapping the first lower electrode portion of the first lower word line (LWL1); and
a second upper electrode portion vertically overlapping the second lower electrode portion of the first lower word line (LWL1),
wherein a length of the second upper electrode portion of the upper word line (UWL1) is greater than the length of the second lower electrode portion of the second lower word line.

8. The semiconductor memory device of any preceding claim, wherein the conductive connection line (CL) is in the interlayer insulating layer (130).

9. The semiconductor memory device of any of claims 1-5, wherein the lower stack (LSS) further comprises:
a second lower word line stacked on the first lower word line (LWL1); and
a second lower channel layer (LCL) at least partially surrounded by the second lower word line,
wherein the first lower word line (LWL1) comprises:
a first lower electrode portion at least partially enclosing the first lower channel layer (LCL); and
a second lower electrode portion in contact with the lower connection contact (LCO),
wherein the second lower word line comprises:
a first lower electrode portion at least partially enclosing the second lower channel layer (LCL); and
a second lower electrode portion in contact with a second lower connection contact (LCO).

10. The semiconductor memory device of claim 9, wherein the first lower channel layer (LCL), the second lower channel layer (LCL), and the upper channel layer (UCL) extend in a first direction, and
a length of the second lower electrode portion of the second lower word line in the first direction is less than a length of the second lower electrode portion of the first lower word line (LWL1) in the first direction.

11. The semiconductor memory device of claim 9 or claim 10, wherein the lower stack (LSS) further comprises a lower bit line connected to the first and second lower channel layers (LCL).

12. The semiconductor memory device of claim 11, wherein the lower stack (LSS) further comprises:
a lower bit line contact on the lower bit line;
a lower bit line connection line on the lower bit line contact; and
a conductive connection line (CL) on the lower connection contact (LCO),
wherein the lower bit line connection line and the conductive connection line (CL) are at a same level relative to a substrate.

13. The semiconductor memory device of claim 12, wherein the interlayer insulating layer (130) at least partially encloses the lower bit line connection line and the conductive connection line (CL).

14. The semiconductor memory device of any preceding claim, wherein a lateral distance between the lower connection contact (LCO) and the penetration contact (CON) is greater than a lateral distance between the penetration contact (CON) and the upper word line (UWL1).

15. The semiconductor memory device of any preceding claim, wherein the upper stack (USS) further comprises an upper connection contact (UCO) on the upper word line (UWL1),
wherein the upper connection contact (UCO) and the lower connection contact (LCO) are vertically overlapping.

## Patentansprüche

1. Halbleiterspeichervorrichtung, umfassend:
einen unteren Stapel (LSS), der eine erste untere Wortleitung (LWL1), eine erste untere Kanalschicht (LCL), die zumindest teilweise von der ersten unteren Wortleitung (LWL1) umschlossen ist, und eine untere Datenspeicherstruktur (LDS), die elektrisch mit der ersten unteren Kanalschicht (LCL) verbunden ist, beinhaltet;
eine Zwischenschichtisolierung (130) auf dem unteren Stapel (LSS); und
einen oberen Stapel (USS) auf der Zwischenschichtisolierungsschicht (130), wobei der obere Stapel (USS) eine obere Wortleitung (UWL1), eine obere Kanalschicht (UCL), die zumindest teilweise von der oberen Wortleitung (UWL1) umschlossen ist, und eine obere Datenspeicherstruktur (UDS), die elektrisch mit der oberen Kanalschicht (UCL) verbunden ist, beinhaltet;
einen unteren Verbindungskontakt (LCO) auf der ersten unteren Wortleitung (LWL1);
eine leitfähige Verbindungsleitung (CL) auf dem unteren Verbindungskontakt (LCO); und
einen Durchdringungskontakt (CON) auf der leitfähigen Verbindungsleitung (CL),
wobei der untere Verbindungskontakt (LCO) die obere Wortleitung (UWL1) vertikal überlappt,
der Durchdringungskontakt (CON) die obere Wortleitung (UWL1) nicht vertikal überlappt,
**dadurch gekennzeichnet, dass**:
der Durchdringungskontakt (CON) den oberen Stapel (USS) durchdringt und über den unteren Verbindungskontakt (LCO) und die leitfähige Verbindungsleitung (CL) elektrisch mit der ersten unteren Wortleitung (LWL1) verbunden ist.

2. Halbleiterspeichervorrichtung nach Anspruch 1, wobei die leitfähige Verbindungsleitung Folgendes umfasst:
einen ersten Abschnitt (P1), der mit einer Oberseite des unteren Verbindungskontakts (LCO) in Kontakt steht;
einen zweiten Abschnitt (P2), der mit einer Unterseite des Durchdringungskontakts (CON) in Kontakt steht; und
einen dritten Abschnitt (P3), der den ersten Abschnitt (P1) mit dem zweiten Abschnitt (P2) verbindet.

3. Halbleiterspeichervorrichtung nach Anspruch 2, wobei der erste Abschnitt (P1) der leitfähigen Verbindungsleitung (CL) die obere Wortleitung (UWL1) vertikal überlappt, und
der zweite Abschnitt (P2) der leitfähigen Verbindungsleitung (CL) die obere Wortleitung (UWL1) vertikal nicht überlappt.

4. Halbleiterspeichervorrichtung nach Anspruch 2 oder Anspruch 3, wobei sich der dritte Abschnitt (P3) der leitfähigen Verbindungsleitung (CL), die erste untere Kanalschicht (LCL) und die obere Kanalschicht (UCL) in einer ersten Richtung erstrecken, und
der erste und der zweite Abschnitt der leitfähigen Verbindungsleitung (CL) sich in einer zweiten Richtung erstrecken, welche die erste Richtung schneidet.

5. Halbleiterspeichervorrichtung nach einem vorstehenden Anspruch, wobei der untere Verbindungskontakt (LCO) und der Durchdringungskontakt (CON) in einer horizontalen Richtung voneinander beabstandet sind.

6. Halbleiterspeichervorrichtung nach einem vorstehenden Anspruch, wobei der untere Stapel (LSS) weiter umfasst:
eine zweite untere Wortleitung, die zwischen der ersten Wortleitung (LWL1) und der Zwischenschichtisolierungsschicht (130) gestapelt liegt; und
eine zweite untere Kanalschicht (LCL), die sich seitlich über die zweite untere Wortlinie hinaus erstreckt,
wobei die erste untere Wortzeile (LWL1) Folgendes umfasst:
einen ersten unteren Elektrodenabschnitt, der die erste untere Kanalschicht (LCL) zumindest teilweise umschließt; und
einen zweiten unteren Elektrodenabschnitt, der mit dem unteren Verbindungskontakt (LCO) in Kontakt steht,
wobei die zweite untere Wortleitung Folgendes umfasst:
einen ersten unteren Elektrodenabschnitt, der den ersten unteren Elektrodenabschnitt der ersten unteren Wortleitung (LWL1) vertikal überlappt; und
einen zweiten unteren Elektrodenabschnitt, der den zweiten unteren Elektrodenabschnitt der ersten unteren Wortleitung (LWL1) vertikal überlappt,
wobei eine Länge des zweiten unteren Elektrodenabschnitts der ersten unteren Wortleitung (LWL1) größer als eine Länge des zweiten unteren Elektrodenabschnitts der zweiten unteren Wortleitung ist.

7. Halbleiterspeichervorrichtung nach Anspruch 6, wobei die obere Wortleitung (UWL1) Folgendes umfasst:
einen ersten oberen Elektrodenabschnitt, der den ersten unteren Elektrodenabschnitt der ersten unteren Wortleitung (LWL1) vertikal überlappt; und
einen zweiten oberen Elektrodenabschnitt, der den zweiten unteren Elektrodenabschnitt der ersten unteren Wortleitung (LWL1) vertikal überlappt,
wobei eine Länge des zweiten oberen Elektrodenabschnitts der ersten oberen Wortleitung (UWL1) größer als die Länge des zweiten unteren Elektrodenabschnitts der zweiten unteren Wortleitung ist.

8. Halbleiterspeichervorrichtung nach einem vorstehenden Anspruch, wobei die leitfähige Verbindungsleitung (CL) in der Zwischenschichtisolierungsschicht (130) liegt.

9. Halbleiterspeichervorrichtung nach einem der Ansprüche 1-5, wobei der untere Stapel (LSS) weiter umfasst:
eine zweite untere Wortleitung, die auf die erste Wortleitung (LWL1) gestapelt liegt; und
eine zweite untere Kanalschicht (LCL), die zumindest teilweise von der zweiten unteren Wortleitung umschlossen ist,
wobei die erste untere Wortzeile (LWL1) Folgendes umfasst:
einen ersten unteren Elektrodenabschnitt, der die erste untere Kanalschicht (LCL) zumindest teilweise umschließt; und
einen zweiten unteren Elektrodenabschnitt, der mit dem unteren Verbindungskontakt (LCO) in Kontakt steht,
wobei die zweite untere Wortleitung Folgendes umfasst:
einen ersten unteren Elektrodenabschnitt, der die zweite untere Kanalschicht (LCL) zumindest teilweise umschließt; und
einen zweiten unteren Elektrodenabschnitt, der mit einem zweiten unteren Verbindungskontakt (LCO) in Kontakt steht.

10. Halbleiterspeichervorrichtung nach Anspruch 9, wobei sich die erste untere Kanalschicht (LCL), die zweite untere Kanalschicht (LCL) und die obere Kanalschicht (UCL) in einer ersten Richtung erstrecken, und
eine Länge des zweiten unteren Elektrodenabschnitts der zweiten unteren Wortleitung in der ersten Richtung geringer als eine Länge des zweiten unteren Elektrodenabschnitts der ersten unteren Wortleitung (LWL1) in der ersten Richtung ist.

11. Halbleiterspeichervorrichtung nach Anspruch 9 oder Anspruch 10, wobei der untere Stapel (LSS) weiter eine untere Bitleitung umfasst, die mit der ersten und der zweiten unteren Kanalschicht (LCL) verbunden ist.

12. Halbleiterspeichervorrichtung nach Anspruch 11, wobei der untere Stapel (LSS) weiter umfasst:
einen unteren Bitleitungskontakt auf der unteren Bitleitung;
eine untere Bitleitungsverbindungsleitung auf dem unteren Bitleitungskontakt; und
eine leitfähige Verbindungsleitung (CL) auf dem unteren Verbindungskontakt (LCO),
wobei die untere Bitleitungsverbindungsleitung und die leitfähige Verbindungsleitung (CL) auf einer gleichen Höhe relativ zu einem Substrat liegen.

13. Halbleiterspeichervorrichtung nach Anspruch 12, wobei die Zwischenschichtisolierungsschicht (130) die untere Bitleitungsverbindungsleitung und die leitfähige Verbindungsleitung (CL) zumindest teilweise umschließt.

14. Halbleiterspeichervorrichtung nach einem vorstehenden Anspruch, wobei ein seitlicher Abstand zwischen dem unteren Verbindungskontakt (LCO) und dem Durchdringungskontakt (CON) größer als ein seitlicher Abstand zwischen dem Durchdringungskontakt (CON) und der oberen Wortleitung (UWL1) ist.

15. Halbleiterspeichervorrichtung nach einem vorstehenden Anspruch, wobei der obere Stapel (USS) weiter einen oberen Verbindungskontakt (UCO) auf der oberen Wortleitung (UWL1) umfasst,
wobei sich der obere Verbindungskontakt (UCO) und der untere Verbindungskontakt (LCO) vertikal überlappen.

## Revendications

1. Dispositif de mémoire semi-conducteur, comprenant :
une pile inférieure (LSS) incluant une première ligne de mots inférieure (LWL1), une première couche de canal inférieure (LCL) au moins partiellement entourée par la première ligne de mots inférieure (LWL1), et une structure de stockage de données inférieure (LDS) électriquement connectée à la première couche de canal inférieure (LCL) ;
une couche isolante intermédiaire (130) sur la pile inférieure (LSS) ; et
une pile supérieure (USS) sur la couche isolante intermédiaire (130), la pile supérieure (USS) incluant une ligne de mots supérieure (UWL1), une couche de canal supérieure (UCL) au moins partiellement entourée par la ligne de mots supérieure (UWL1) et une structure de stockage de données supérieure (UDS) électriquement connectée à la couche de canal supérieure (UCL) ;
un contact de connexion inférieur (LCO) sur la première ligne de mots inférieure (LWL1) ;
une ligne de connexion conductrice (CL) sur le contact de connexion inférieur (LCO) ; et
un contact de pénétration (CON) sur la ligne de connexion conductrice (CL)
dans lequel le contact de connexion inférieur (LCO) chevauche verticalement la ligne de mots supérieure (UWL1),
le contact de pénétration (CON) ne chevauche pas verticalement la ligne de mots supérieure (UWL1),
**caractérisé en ce que** :
le contact de pénétration (CON) pénètre la pile supérieure (USS) et est électriquement connecté à la première ligne de mots inférieure (LWL1) via le contact de connexion inférieur (LCO) et la ligne de connexion conductrice (CL).

2. Dispositif de mémoire semi-conducteur selon la revendication 1, dans lequel la ligne de connexion conductrice comprend :
une première partie (P1) en contact avec une surface supérieure du contact de connexion inférieur (LCO) ;
une deuxième partie (P2) en contact avec une surface inférieure du contact de pénétration (CON) ; et
une troisième partie (P3) connectant la première partie (P1) à la deuxième partie (P2).

3. Dispositif de mémoire semi-conducteur selon la revendication 2, dans lequel la première partie (P1) de la ligne de connexion conductrice (CL) chevauche verticalement la ligne de mots supérieure (UWL1), et
la deuxième partie (P2) de la ligne de connexion conductrice (CL) ne chevauche pas verticalement la ligne de mots supérieure (UWL1).

4. Dispositif de mémoire semi-conducteur selon la revendication 2 ou la revendication 3, dans lequel la troisième partie (P3) de la ligne de connexion conductrice (CL), la première couche de canal inférieure (LCL) et la couche de canal supérieure (UCL) s'étendent dans une première direction, et
les première et deuxième parties de la ligne de connexion conductrice (CL) s'étendent dans une seconde direction qui croise la première direction.

5. Dispositif de mémoire semi-conducteur selon une quelconque revendication précédente, dans lequel le contact de connexion inférieur (LCO) et le contact de pénétration (CON) sont espacés l'un de l'autre dans une direction horizontale.

6. Dispositif de mémoire semi-conducteur selon une quelconque revendication précédente, dans lequel la pile inférieure (LSS) comprend en outre :
une seconde ligne de mots inférieure empilée entre la première ligne de mots inférieure (LWL1) et la couche isolante intermédiaire (130) ; et
une seconde couche de canal inférieure (LCL) s'étendant latéralement au-delà de la seconde ligne de mots inférieure,
dans lequel la première ligne de mots inférieure (LWL1) comprend :
une première partie d'électrode inférieure englobant au moins partiellement la première couche de canal inférieure (LCL) ; et
une seconde partie d'électrode inférieure en contact avec le contact de connexion inférieur (LCO),
dans lequel la seconde ligne de mots inférieure comprend :
une première partie d'électrode inférieure chevauchant verticalement la première partie d'électrode inférieure de la première ligne de mots inférieure (LWL1) ; et
une seconde partie d'électrode inférieure chevauchant verticalement la seconde partie d'électrode inférieure de la première ligne de mots inférieure (LWL1),
dans lequel la longueur de la seconde partie d'électrode inférieure de la première ligne de mots inférieure (LWL1) est supérieure à la longueur de la seconde partie d'électrode inférieure de la seconde ligne de mots inférieure.

7. Dispositif mémoire semi-conducteur selon la revendication 6, dans lequel la ligne de mots supérieure (UWL1) comprend :
une première partie d'électrode supérieure chevauchant verticalement la première partie d'électrode inférieure de la première ligne de mots inférieure (LWL1) ; et
une seconde partie d'électrode supérieure chevauchant verticalement la seconde partie d'électrode inférieure de la première ligne de mots inférieure (LWL1),
dans lequel la longueur de la seconde partie d'électrode supérieure de la ligne de mots supérieure (UWL1) est supérieure à la longueur de la seconde partie d'électrode inférieure de la seconde ligne de mots inférieure.

8. Dispositif de mémoire semi-conducteur selon une quelconque revendication précédente, dans lequel la ligne de connexion conductrice (CL) se trouve dans la couche isolante intermédiaire (130).

9. Dispositif de mémoire semi-conducteur selon l'une quelconque des revendications 1-5, dans lequel la pile inférieure (LSS) comprend en outre :
une seconde ligne de mots inférieure empilée sur la première ligne de mots inférieure (LWL1) ; et
une seconde couche de canal inférieure (LCL) au moins partiellement entourée par la seconde ligne de mots inférieure,
dans lequel la première ligne de mots inférieure (LWL1) comprend :
une première partie d'électrode inférieure englobant au moins partiellement la première couche de canal inférieure (LCL) ; et
une seconde partie d'électrode inférieure en contact avec le contact de connexion inférieur (LCO),
dans lequel la seconde ligne de mots inférieure comprend :
une première partie d'électrode inférieure englobant au moins partiellement la seconde couche de canal inférieure (LCL) ; et
une seconde partie d'électrode inférieure en contact avec un second contact de connexion inférieur (LCO).

10. Dispositif de mémoire semi-conducteur selon la revendication 9, dans lequel la première couche de canal inférieure (LCL), la seconde couche de canal inférieure (LCL) et la couche de canal supérieure (UCL) s'étendent dans une première direction, et
la longueur de la seconde partie d'électrode inférieure de la seconde ligne de mots inférieure dans la première direction est inférieure à la longueur de la seconde partie d'électrode inférieure de la première ligne de mots inférieure (LWL1) dans la première direction.

11. Dispositif de mémoire semi-conducteur selon la revendication 9 ou la revendication 10, dans lequel la pile inférieure (LSS) comprend en outre une ligne de bits inférieure connectée aux première et seconde couches de canal inférieures (LCL).

12. Dispositif de mémoire semi-conducteur selon la revendication 11, dans lequel la pile inférieure (LSS) comprend en outre :
un contact de ligne de bits inférieure sur la ligne de bits inférieure ;
une ligne de connexion de ligne de bits inférieure sur le contact de ligne de bits inférieure ; et
une ligne de connexion conductrice (CL) sur le contact de connexion inférieur (LCO),
dans lequel la ligne de connexion de ligne de bits inférieure et la ligne de connexion conductrice (CL) sont au même niveau par rapport à un substrat.

13. Dispositif de mémoire semi-conducteur selon la revendication 12, dans lequel la couche isolante intermédiaire (130) englobe au moins partiellement la ligne de connexion de ligne de bits inférieure et la ligne de connexion conductrice (CL).

14. Dispositif de mémoire semi-conducteur selon une quelconque revendication précédente, dans lequel une distance latérale entre le contact de connexion inférieur (LCO) et le contact de pénétration (CON) est supérieure à une distance latérale entre le contact de pénétration (CON) et la ligne de mots supérieure (UWL1).

15. Dispositif de mémoire semi-conducteur selon une quelconque revendication précédente, dans lequel la pile supérieure (USS) comprend en outre un contact de connexion supérieur (UCO) sur la ligne de mots supérieure (UWL1),
dans lequel le contact de connexion supérieur (UCO) et le contact de connexion inférieur (LCO) se chevauchent verticalement.
